# EUROPEAN PATENT APPLICATION

(11) **EP 2 275 494 A1**
(43) Date of publication of application: **19.01.2011**
(21) Application number: 09733937.8
(22) Date of filing: 23.04.2009
(51) Int. Cl.: C09B 57/10, C07F 15/00, H01L 31/04, H01M 14/00

(54) **PYRIDINE-TYPE METAL COMPLEX, PHOTOELECTRODE COMPRISING THE METAL COMPLEX, AND DYE-SENSITIZED SOLAR CELL COMPRISING THE PHOTOELECTRODE**

(30) Priority: 24.04.2008 JP 2008114178
(71) Applicant: Sharp Kabushiki Kaisha, Osaka-shi Osaka 545-8522 (JP)
(72) Inventor: Shen, Xiuliang., Osaka-shi , Osaka 545-8522 (JP); Islam, Ashraful., Ibaraki 305-0032 (JP); Komiya, Ryoichi, Osaka-shi , Osaka 545-8522 (JP); Han, Liyuan., Nara 635-0015 (JP)
(74) Representative: Müller - Hoffmann & Partner
(86) International application number: PCT/JP2009/058085
(87) International publication number: WO 2009/131183

(57) **Abstract**

A pyridine type metal complex having a partial structure represented by the formula (I) or (I'): 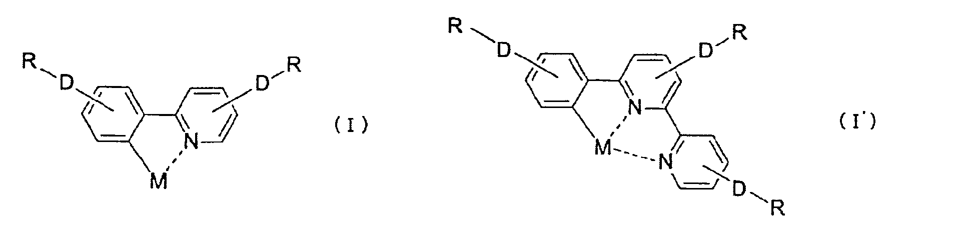 wherein,
M is a transition metal atom; Ds, which may be the same or different, respectively represent specific conjugated chains; Rs, which may be the same or different, respectively represent a halogen atom, a hydrogen atom, or an alkyl group having 1 to 20 carbon atoms, an alkenyl or alkynyl group having 2 to 10 carbon atoms, an aryl or heteroaryl group having 6 to 10 carbon atoms or an arylalkyl or heteroarylalkyl group having 7 to 13 carbon atoms which may have a substituent group.

## Description

### TECHNICAL FIELD

The present invention relates to a new pyridine type metal complex and a photoelectrode comprising the metal complex and a dye-sensitized solar cell comprising the photoelectrode.

### BACKGROUND ART

Among solar photovoltaic technologies, dye-sensitized solar cells disclosed in Japanese Patent No. 2664194 (Patent Document 1) and B. O'Regan et al., "A Low-cost, High-efficiency Solar Cell based on Dye-sensitized Collidal TiO2 Films", Nature, 1991, vol. 353, pp. 737-740 (Non-patent Document 1) have drawn attention in recent years since the cells do not require high purity silicon semiconductor, the cells can be configured with relatively economical materials and fabricated by printing process easy to handle, and thus it is expected that the cost can be reduced.

Regarding such a dye-sensitized solar cell, a main part includes three parts; a semiconductor photoelectrode (also referred to as "photoelectrode"), an electrolyte solution of a redox type or the like, and a counter electrode.
A semiconductor such as TiO₂ to be used for the photoelectrode has a wide band gap and therefore, is used by itself only sunlight in an ultraviolet ray region; however owing to sensitization of a dye adsorbed on the semiconductor, photoelectric conversion is achieved using sunlight in a visible light region.
Accordingly, development of sensitizing dyes has been raised as an important issue for practical use of dye-sensitized solar cells.

A polypyridine ruthenium (Ru) type dye which has been used as a sensitizing dye in dye-sensitized solar cells has drawn attention because of its wider light absorption than an organic dye, relatively high stability, and also high conversion efficiency.
However, in order to use the dye for practically usable solar cells, a further higher conversion efficiency has to be achieved and high stability for a long duration without deterioration to an outside load is also required.

### PRIOR ART DOCUMENTS

### Patent Document

Patent Document 1: Japanese Patent No. 2664194

### Non-patent Document

Non-patent Document 1: B. O'Regan et al., "A Low-cost, High-efficiency Solar Cell based on Dye-sensitized Collidal TiO2 Films", Nature, 1991, vol. 353, pp. 737-740

### DISCLOSURE OF THE INVENTION

### Problems that the Invention it to Solve

The present invention aims to provide a new organic metal complex having a wide absorption band and excellent stability, and a photoelectrode comprising the metal complex and a dye-sensitized solar cell comprising the photoelectrode.

### Means for Solving the Problems

Accordingly, the present invention provides a pyridine type metal complex having a partial structure represented by the formula (I) or (I'):

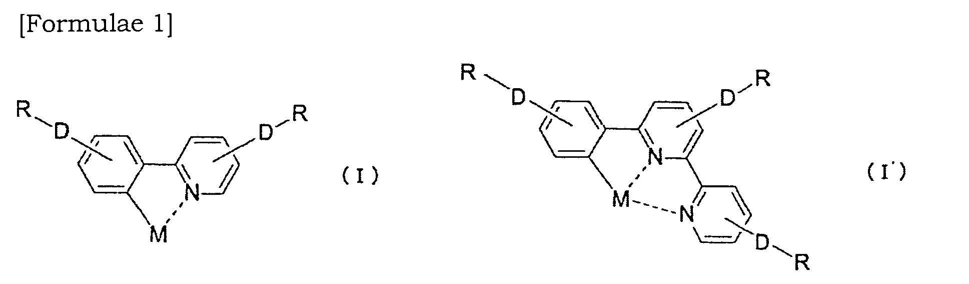

wherein,
M is a transition metal atom;
Ds, which may be the same or different, respectively represent any one of conjugated chains represented by structural formulae (2) to (11),

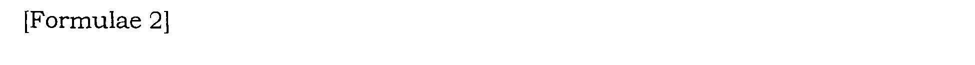

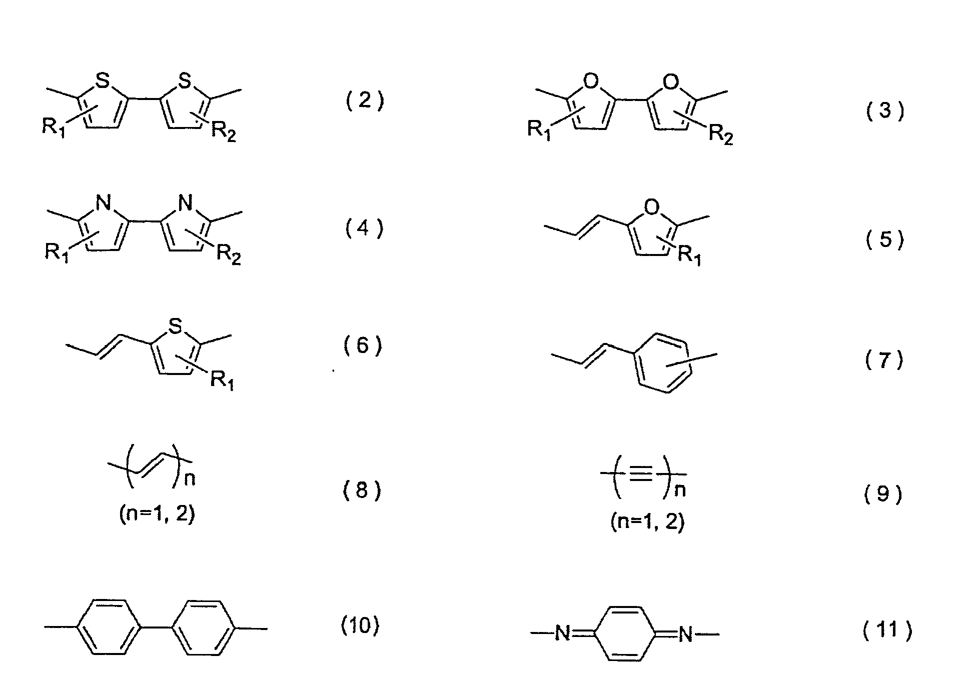

wherein R₁ and R₂, which may be the same or different, respectively represent an alkyl group having 1 to 20 carbon atoms;
Rs, which may be the same or different, respectively represent a halogen atom, a hydrogen atom, or an alkyl group having 1 to 20 carbon atoms, an alkenyl or alkynyl group having 2 to 10 carbon atoms, an aryl or heteroaryl group having 6 to 10 carbon atoms or an arylalkyl or heteroarylalkyl group having 7 to 13 carbon atoms which may have a substituent group..

Further, the present invention provides a photoelectrode comprising adsorbing the above-mentioned metal complex onto a surface of a semiconductor layer.
Furthermore, the present invention provides a dye-sensitized solar cell comprising the above-mentioned photoelectrode.

### Effects of the Invention

According to the present invention, a new organic metal complex having a wide absorption band and excellent stability, a photoelectrode comprising the metal complex, and a dye-sensitized solar cell comprising the photoelectrode can be provided.
It is expected that the organic metal complex of the present invention is applicable for a photocatalyst for water decomposition or the like, a photoelectronic device and the like other than a sensitizing dye for the photoelectrode of the present invention.

### BRIEF DESCRIPTION OF THE DRAWINGS

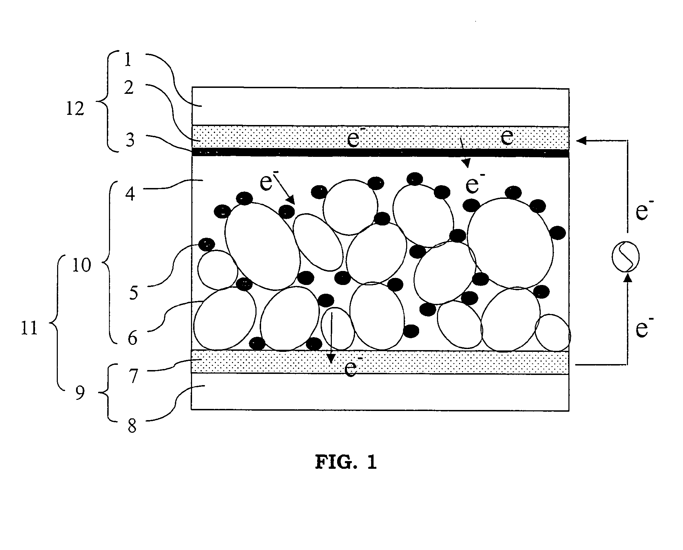

[Fig. 1] A schematic cross-sectional view showing one example of a layer structure of a dye-sensitized solar cell comprising a photoelectrode of the present invention.

### MODES FOR CARRYING OUT THE INVENTION

The pyridine type metal complex of the present invention is characterized by including a partial structure represented by the formula (I) or (I').

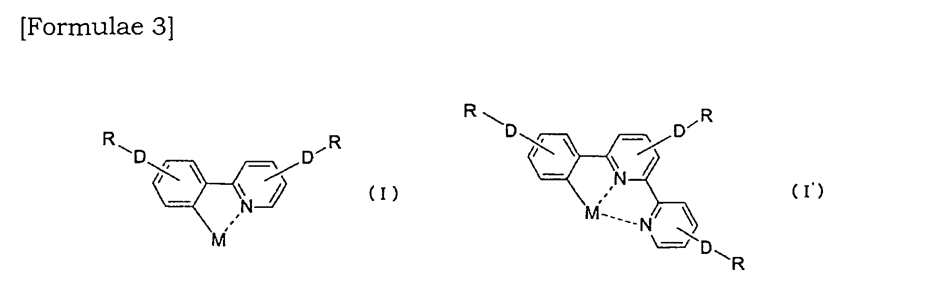

### Substituent groups in the formula (I) or (I') will be described.

M in the formula (I) or (I') represents a core metal of the pyridine type metal complex of the present invention and a metal atom thereof is not particularly limited as long as it can form a metal complex by coordinating a pyridine derivative as a ligand. Specific examples of metal atoms capable of forming a tetracoordinate or a hexacoordinate include Ru, Fe, Os, Cu, W, Cr, Mo, Ni, Pd, Pt, Co, Ir, Rh, Re, Mn and Zn. Among these, Ru, Fe, Os, and Cu are preferable and Ru is particularly preferable.

Ds in the formula (I) or (I'), which may be the same or different, respectively represent any one of conjugated chains represented by the structural formulae (2) to (11).

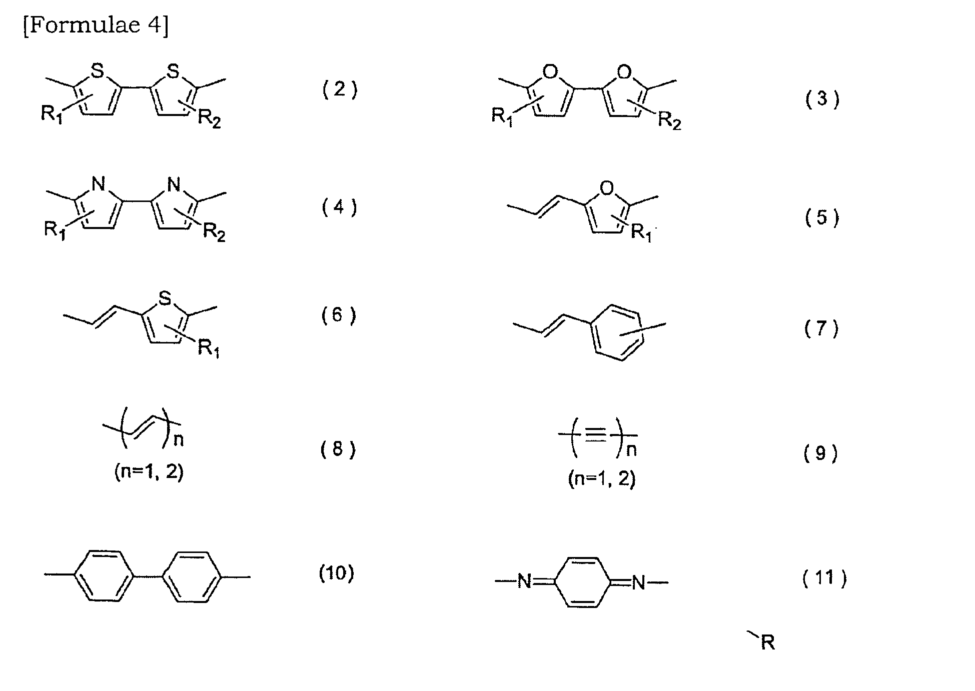

R₁ and R₂ in the formulae (2) to (6) are, which may be the same or different, respectively represent an alkyl group having 1 to 20 carbon atoms.
Examples of the alkyl group include straight chain, branched chain or cyclic alkyl groups having 1 to 20 carbon atoms such as methyl, ethyl, propyl, isopropyl, butyl, isobutyl, sec-butyl, tert-butyl, pentyl, isopentyl, hexyl, cyclohexyl, octyl and decyl.

Rs in the formula (I) or (I'), which may be the same or different, respectively represent a halogen atom, a hydrogen atom, or an alkyl group having 1 to 20 carbon atoms, an alkenyl or alkynyl group having 2 to 10 carbon atoms, an aryl or heteroaryl group having 6 to 10 carbon atoms, or an arylalkyl or heteroarylalkyl group having 7 to 13 carbon atoms which may have a substituent group.

Examples of the halogen atom include fluorine, chlorine, bromine and iodine, and chlorine and bromine are particularly preferable.

Examples of the alkyl group include those exemplified for R₁ and R₂ in the formula (2).

Examples of the alkenyl group include straight chain or branched chain alkenyl groups having 2 to 10 carbon atoms such as vinyl, allyl, isopropenyl, butenyl, 2-methyl-1-propenyl, 2-methyl-2-propenyl and 1-methyl-propenyl.

Examples of the alkynyl group include straight chain or branched chain alkynyl groups having 2 to 10 carbon atoms such as ethynyl, 1-propynyl, 2-propynyl, 1-butynyl, 2-butynyl and 3-butynyl.

Examples of the aryl group include phenyl, (1- or 2-)naphthyl and an aryl group having 6 to 10 ring atoms. In the present invention, the aryl group includes an ortho-fused bicyclic group having 5 to 10 ring atoms in which at least one ring is an aromatic ring (e.g. indenyl).

Examples of the heteroaryl group include a 5-membered ring or 6-membered ring, or condensed ring containing at least a nitrogen atom, a sulfur atom or an oxygen atom such as pyrrolyl, furyl, thienyl, oxazolyl, isoxazolyl, imidazolyl, thiazolyl, isothiazolyl, pyrazolyl, triazolyl, tetrazolyl, 1,2,4-oxadiazolyl, 1,2,4-thiadiazolyl, pyridyl, pyranyl, pyrazinyl, pyrimidinyl, pyridazinyl, 1,2,4-triazinyl, 1,2,3-triazinyl, 1,3,5-triazinyl, 1,2,5-oxathiazinyl, 1,2,6-oxathiazinyl, benzoxazolyl, benzothiazolyl, benzoimidazolyl, thianaphthenyl, isothianaphthenyl, benzofuranyl, isobenzofuranyl, chromenyl, isoindolyl, indolyl, indazolyl, isoquinolyl, quinolyl, phthalazinyl, quinoxalinyl, quinazolinyl, cinnolinyl and benzoxazinyl.

Examples of the arylalkyl group include those in which an aryl part thereof is the same as described above and an alkyl part thereof is preferably a straight chain or branched chain alkyl group having 1 to 3 carbon atoms. Specifically, examples thereof include benzyl, phenylethyl, 3-phenylpropyl, 1-naphthylmethyl, 2-naphthylmethyl, 2-(1-naphthyl)ethyl, 2-(2-naphthyl)ethyl, 3-(1-naphthyl)propyl and 3-(2-naphthyl)propyl.

Examples of the heteroarylalkyl group include those in which a heteroaryl part thereof is the same as described above and an alkyl part thereof is preferably a straight chain or branched chain alkyl group having 1 to 3 carbon atoms. Specifically, examples thereof include 2-pyrrolylmethyl, 2-pyridylmethyl, 3-pyridylmethyl, 4-pyridylmethyl, 2-thienylmethyl, 2-(2-pyridyl)ethyl, 2-(3-pyridyl)ethyl, 2-(4-pyridyl)ethyl and 3-(2-pyrrolyl)propyl.

The above-mentioned R may have a substituent group such as a lower alkyl group and the "lower" means 1 to 6 carbon atoms and at least one hydrogen atom in the lower alkyl group may be substituted with a halogen atom.
Further, the substituent group may have a configuration that the group is optionally protected with a known protection group.
The number of the substituent group is generally 1 to 3 and in a case where the number is two or more, the substituent groups may be the same or different, respectively and examples thereof include a mesityl which is a phenyl group having 3 methyl groups at positions 2, 4 and 6.

The pyridine type metal complex of the present invention is preferably represented by
the formula (12): ML₁(L₄)₂;
the formula (13): ML₁L₃L₄;
the formula (14): ML₁L₅X or
the formula (15): ML₂L₅;

wherein
L₁ represents a phenylpyridyl ligand;
L₂ represents a phenylbipyridyl ligand;
L₃ represents a substituent group (D-R-) described in claim 1 or a bidentate pyridyl ligand including an alkyl group having 1 to 20 carbon atoms, an alkenyl or alkynyl group having 2 to 10 carbon atoms, an aryl or heteroaryl group having 6 to 10 carbon atoms, or an arylalkyl or heteroarylalkyl group having 7 to 13 carbon atoms which may have a substituent group;
L₄ represents a bidentate pyridyl ligand having a carboxyl group, a sulfonic acid group, a hydroxyl group, a hydroxamic acid group, a phosphoryl group, or a phosphonyl group and two L₄ in the formula (12) are the same or different; and
L₅ represents a tridentate pyridyl ligand having a carboxyl group, a sulfonic acid group, a hydroxyl group, a hydroxamic acid group, a phosphoryl group, or a phosphonyl group;

X represents a monodentate ligand coordinated with a group selected from acyloxy, acylthio, thioacyloxy, thioacylthio, acylaminoxy, thiocarbamate, dithiocarbamate, thiocarbonate, dithiocarbonate, trithiocarbonate, acyl, thiocyanate, isothiocyanate, cyanate, isocyanate, cyano, alkylthio, arylthio, alkoxy and aryloxy, or a monodentate ligand including a halogen atom, carbonyl, dialkyl ketone, 1,3-diketone, carbonamide, thiocarbonamide, thiourea, or isothiourea; and
M is a metal atom of Ru, Fe, Os, Cu, W, Cr, Mo, Ni, Pd, Pt, Co, Ir, Rh, Re, Mn or Zn.

The ligands and substituent groups in the formulae (12), (13), (14) and (15) will be described.
The phenylpyridyl ligand for L₁ in the formulae (12), (13) and (14) and the phenylbipyridyl ligand for L₂ in the formula (15) are preferably ligands derived from the formulae (16) and (17), respectively:

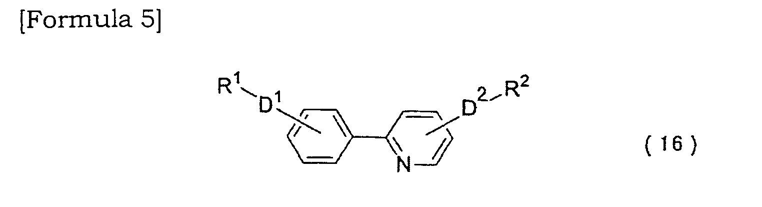

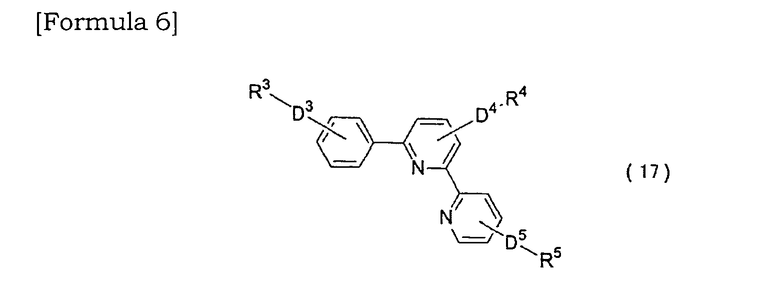

wherein
D¹, D², D³, D⁴ and D⁵, which may be the same or different, respectively represent any one of conjugated chains represented by the structural formulae (2) to (11) and D¹ and D² in the formula (16) and D³, D⁴, and D⁵ in the formula (17) are the same or different,
R¹, R², R³, R⁴ and R⁵, which may be the same or different, respectively represent a halogen atom, a hydrogen atom, or an alkyl group having 1 to 20 carbon atoms, an alkenyl or alkynyl group having 2 to 10 carbon atoms, an aryl or heteroaryl group having 6 to 10 carbon atoms, or an arylalkyl or heteroarylalkyl group having 7 to 13 carbon atoms which may have a substituent group.

The bidentate pyridyl ligand for L₃ in the formula (13) is preferably a ligand derived from the formula (18):

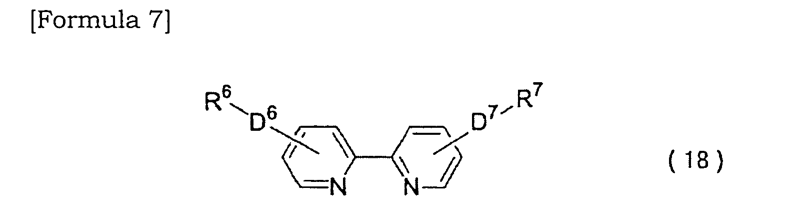

wherein
D⁶ and D⁷ , which may be the same or different, respectively represent any one of conjugated chains represented by the structural formulae (2) to (11) described in claim 1 and D⁶ and D⁷ in the formula (18) are the same or different respectively;
R⁶ and R⁷, which may be the same or different, respectively represent a halogen atom, a hydrogen atom, or an alkyl group having 1 to 20 carbon atoms, an alkenyl or alkynyl group having 2 to 10 carbon atoms, an aryl or heteroaryl group having 6 to 10 carbon atoms, or an arylalkyl or heteroarylalkyl group having 7 to 13 carbon atoms which may have a substituent group.

The bidentate pyridyl ligand for L₄ in the formulae (12) and (13) is preferably selected from bidentate ligands derived from the following formulae (19) to (22).

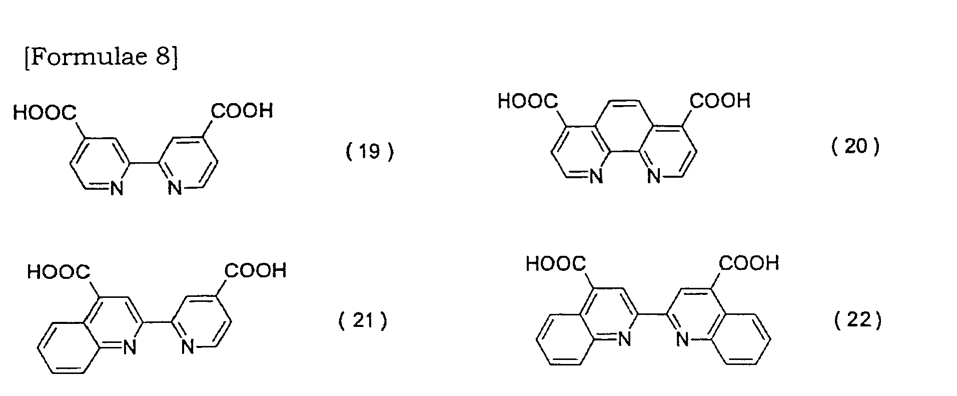

The ligand L₅ in the formulae (14) and (15) is preferably selected from tridentate ligands derived from the following formulae (23) to (28).

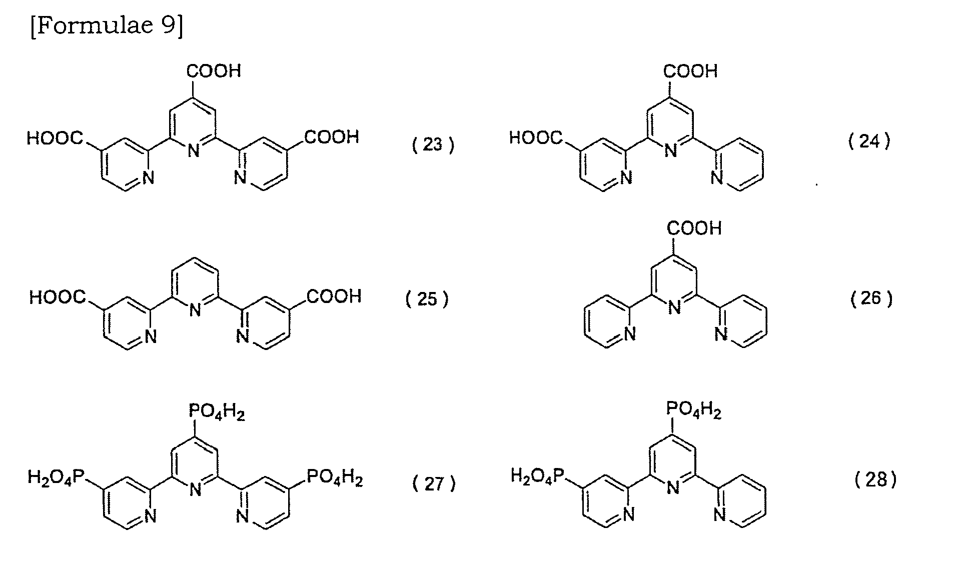

Examples of the alkyl group having 1 to 20 carbon atoms, the alkenyl or alkynyl group having 2 to 10 carbon atoms, the aryl or heteroaryl group having 6 to 10 carbon atoms, and the arylalkyl or heteroarylalkyl group having 7 to 13 carbon atoms which the bidentate ligand in the formula (14) may have include those exemplified for R in the formula (I) or (I').

The substituent groups for the formulae (16), (17) and (18) will be described.
Examples of the halogen atom for R¹, R², R³, R⁴, R⁵, R⁶ and R⁷ include those exemplified for R in the formula (I) or (I').
Further, examples of the alkyl group having 1 to 20 carbon atoms, the alkenyl or alkynyl group having 2 to 10 carbon atoms, the aryl or heteroaryl group having 6 to 10 carbon atoms and the arylalkyl or heteroarylalkyl group having 7 to 13 carbon atoms which may have a substituent group for R¹, R², R³, R⁴, R⁵, R⁶ and R⁷ include those exemplified for R in the formula (I) or (I').

H⁺ as a portion of the substituent group (e.g. -COOH) in the ligands L₄ and L₅ may be substituted with tetrabutylammonium cation. However, in order to adsorb onto a surface of a semiconductor layer, at least one substituent group which is not substituted with tetrabutylammonium cation or the like is required.

The X in the above-mentioned formula (14) is particularly preferably a thiocyanate group (-NCS) and a cyano group (-CN).

The pyridine type metal complex represented by the formula (12) is preferably a metal complex selected from the following formulae (29) to (32) and particularly preferably a metal complex represented by the formula (29).

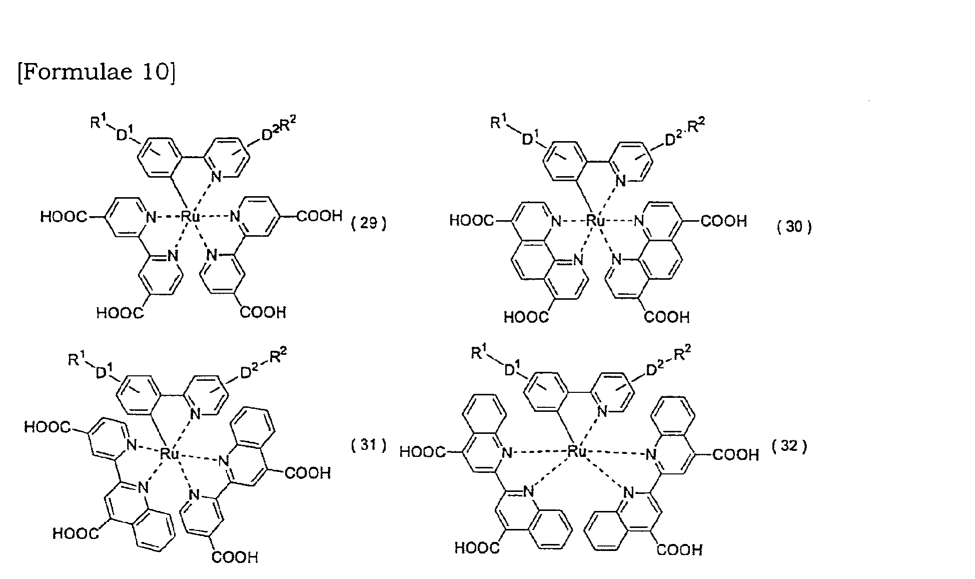

The pyridine type metal complex represented by the formula (13) is preferably a metal complex selected from the following formulae (33) to (36) and particularly preferably a metal complex represented by the formula (33).

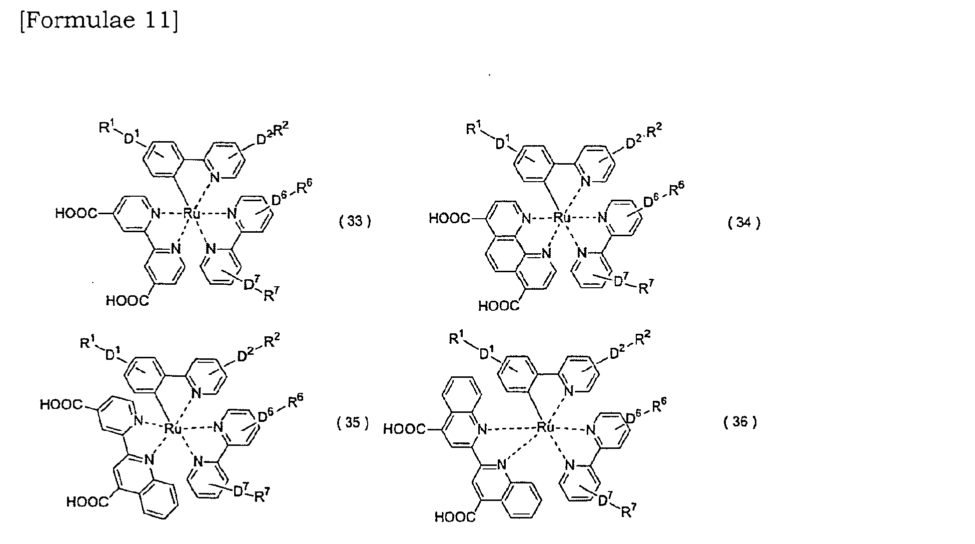

The pyridine type metal complex represented by the formula (14) is preferably a metal complex selected from the following formulae (37) to (40) and particularly preferably a metal complex represented by the formula (37).

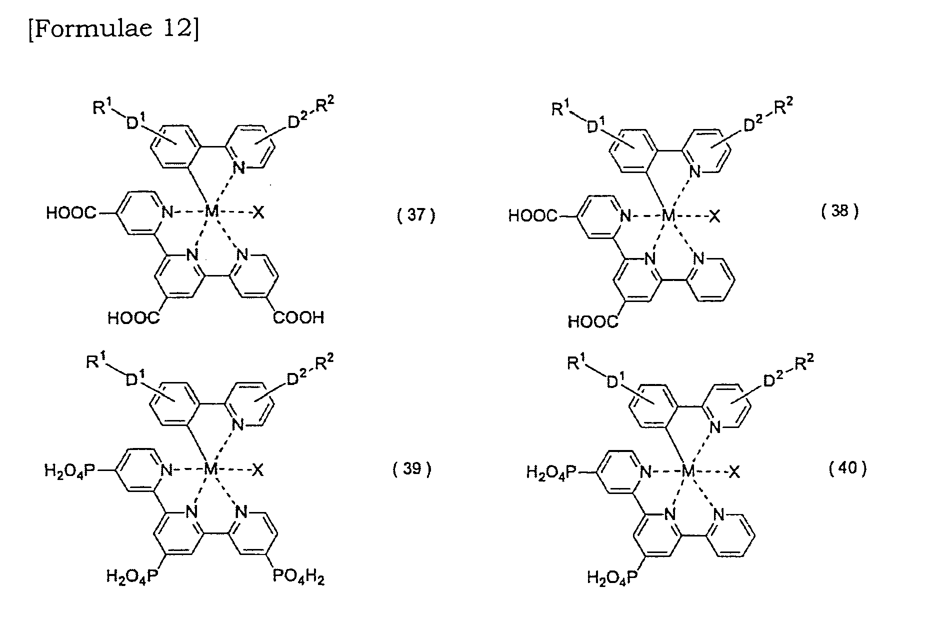

The pyridine type metal complex represented by the formula (15) is preferably a metal complex selected from the following formulae (41) and (42) and particularly preferably a metal complex represented by the formula (41).

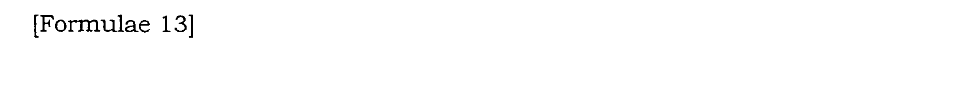

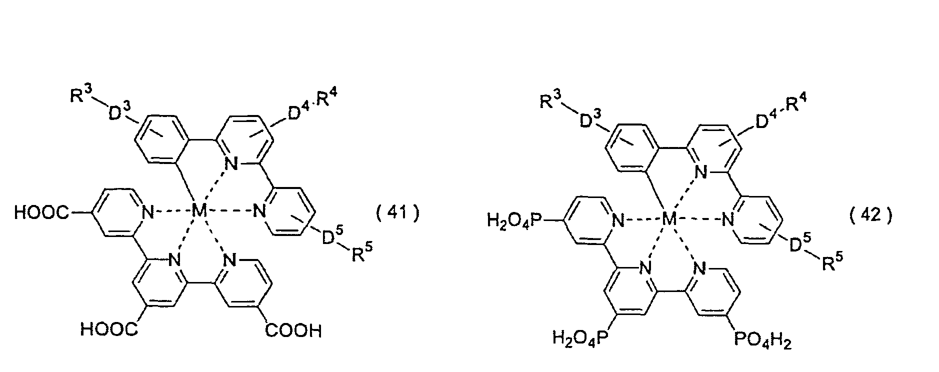

A method for producing the pyridine type metal complex of the present invention represented by the formulae (12) to (15) will be described.
A new pyridine type metal complex (29) represented by the formula (12) can be produced, for example, as follows.

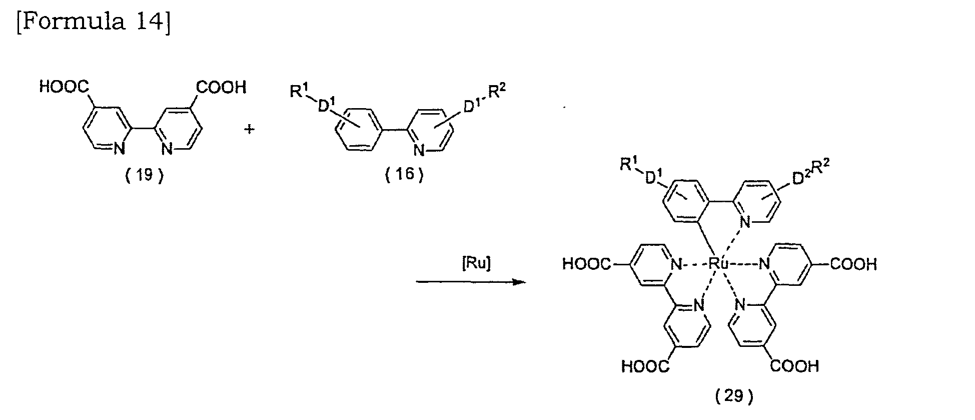

wherein D¹, D², R¹ and R² are as described above.
In the reaction formula, for example, a 0.5- to 50-fold molar quantity of a ruthenium transition metal reagent [Ru] is added relative to 1 mole of a ligand represented by the formula (19) and refluxed in a solvent (a halogen solvent or a N,N-dimethylformamide solvent, e.g., dichloromethane, chloroform, toluene, dichloroethane or N,N-dimethylformamide mixed with an alcohol such as methanol or ethanol). A reaction temperature and a reaction time are about 50 to 150°C and about 12 to 48 hours, respectively, although depending on a type of the solvent and the like.
Next, a 1 to 20-fold molar quantity of a ligand represented by the formula (16) is added and the reaction mixture is further refluxed at the same temperature for the same reaction time.
Finally, an obtained reaction product is separated by a known method and refined if necessary to obtain the desired metal complex (29).

A new pyridine type metal complex (33) represented by the formula (13) can be produced, for example, as follows.

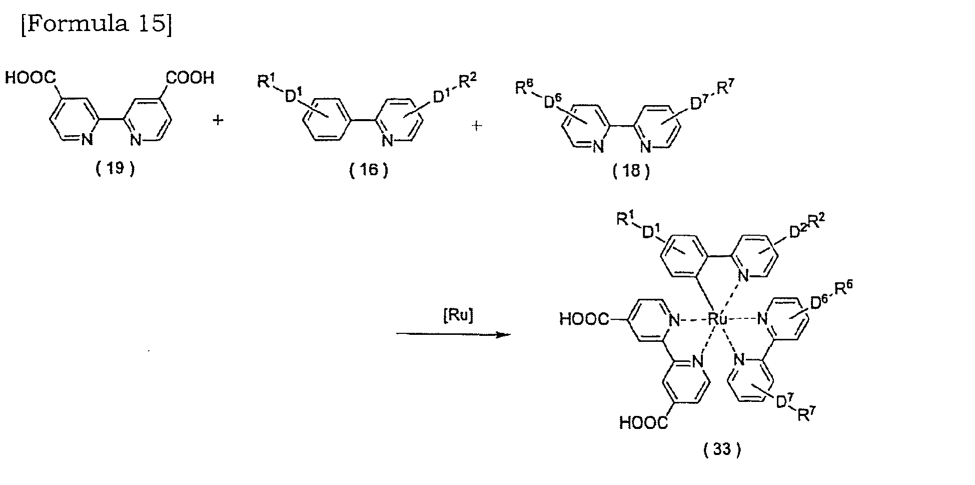

wherein D¹, D², D⁶ D⁷, R¹, R², R⁶ and R⁷ are as described above.
In the reaction formula, for example, a 0.5- to 50-fold molar quantity of a ruthenium transition metal reagent [Ru] is added relative to 1 mole of a ligand represented by the formula (18) and refluxed in a solvent (a halogen solvent or a N,N-dimethylformamide solvent, e.g., dichloromethane, chloroform, toluene, dichloroethane, or N,N-dimethylformamide mixed with an alcohol such as methanol or ethanol). A reaction temperature and a reaction time are about 50 to 150°C and about 12 to 48 hours, respectively, although depending on a type of the solvent and the like. Next, a 1- to 20-fold molar quantity of a ligand represented by the formula (16) is added and the reaction mixture is further refluxed at the same temperature for the same reaction time. Finally, an obtained reaction product is separated by a known method and refined if necessary to obtain the desired metal complex (33).

A new pyridine type metal complex (37) represented by the formula (14) can be produced, for example, as follows.

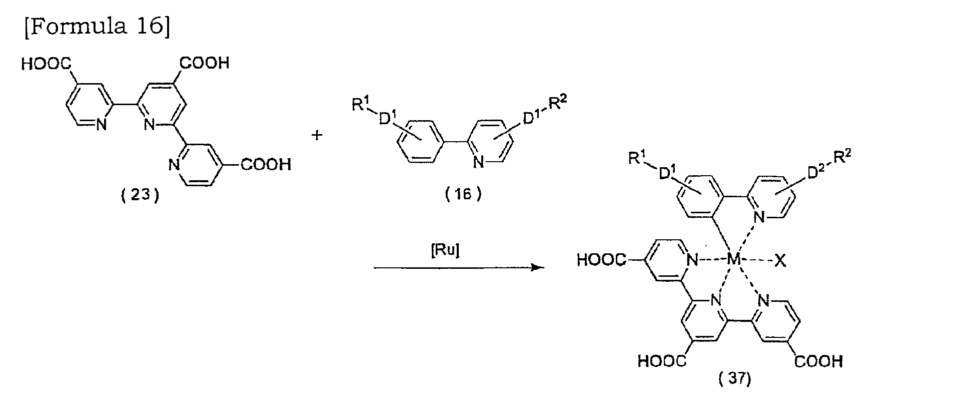

wherein D¹, D², R¹, R² and X are as described above.
In the reaction formula, for example, a 0.5- to 50-fold molar quantity of a ruthenium transition metal reagent [Ru] is added relative to 1 mole of a ligand represented by the formula (23) and refluxed in a solvent (a halogen solvent or a N,N-dimethylformamide solvent, e.g., dichloromethane, chloroform, toluene, dichloroethane, or N,N-dimethylformamide mixed with an alcohol such as methanol or ethanol). A reaction temperature and a reaction time are about 50 to 150°C and about 12 to 48 hours, respectively, although depending on a type of the solvent and the like.
Next, a 1- to 20-fold molar quantity of a ligand represented by the formula (16) is added and the reaction mixture is further refluxed at the same temperature for the same reaction time.
Finally, an obtained reaction product is separated by a known method and refined if necessary to obtain the desired metal complex (37).

A new pyridine type metal complex (41) represented by the formula (15) can be produced, for example, as follows.

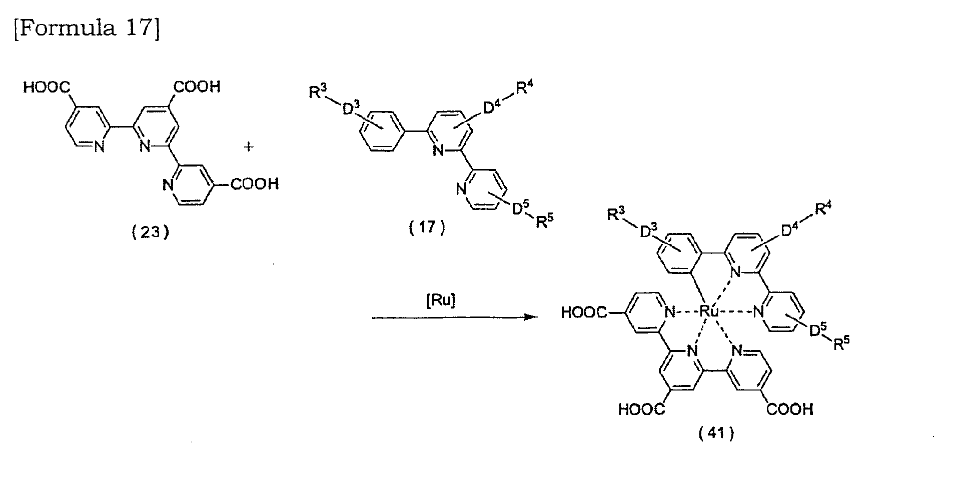

wherein D³, D⁴, D⁶, R³, R⁴ and R⁶ are as described above.
In the reaction formula, for example, a 0.5- to 50-fold molar quantity of a ruthenium transition metal reagent [Ru] is added relative to 1 mole of a ligand represented by the formula (23) and refluxed in a solvent (a halogen solvent or a N,N-dimethylformamide solvent, e.g., dichloromethane, chloroform, toluene, dichloroethane, or N,N-dimethylformamide mixed with an alcohol such as methanol or ethanol). A reaction temperature and a reaction time are about 50 to 150°C and about 12 to 48 hours, respectively, although depending on a type of the solvent and the like.
Next, a 1- to 20-fold molar quantity of a ligand represented by the formula (17) is added and the reaction mixture is further refluxed at the same temperature for the same reaction time.
Finally, an obtained reaction product is separated by a known method and refined if necessary to obtain the desired metal complex (41).

A pyridine type metal complex having a partial structure represented by the formula (I) or (I') can be classified according to the above-mentioned formulae (12) to (15).

The pyridine type metal complex represented by the formula (12) can be represented by the general formulae (29) to (32) and, more specifically, it is preferably a metal complex represented by the formulae (50) to (59).

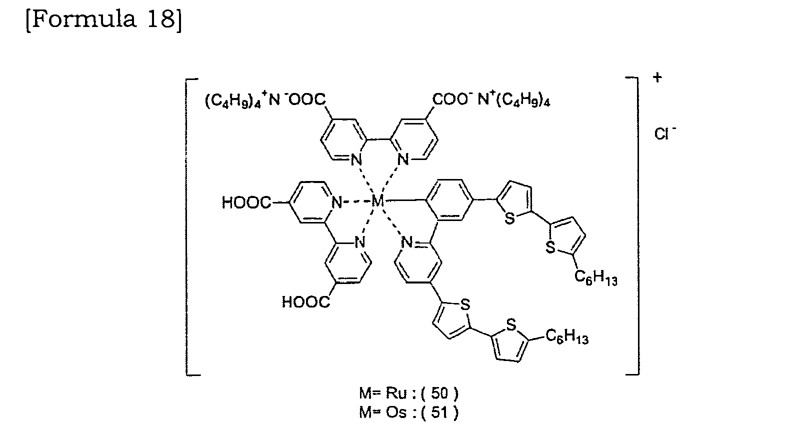

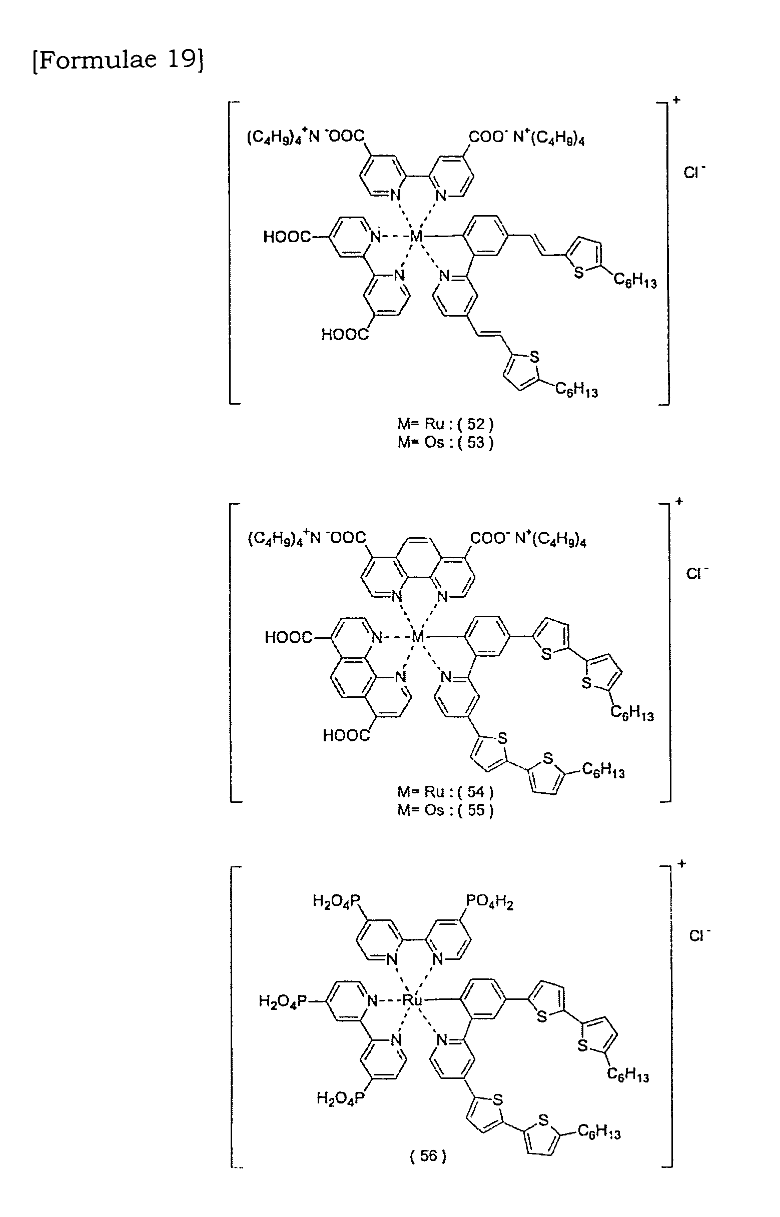

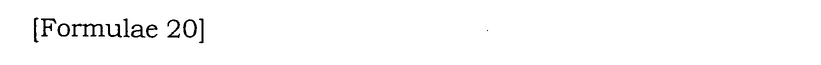

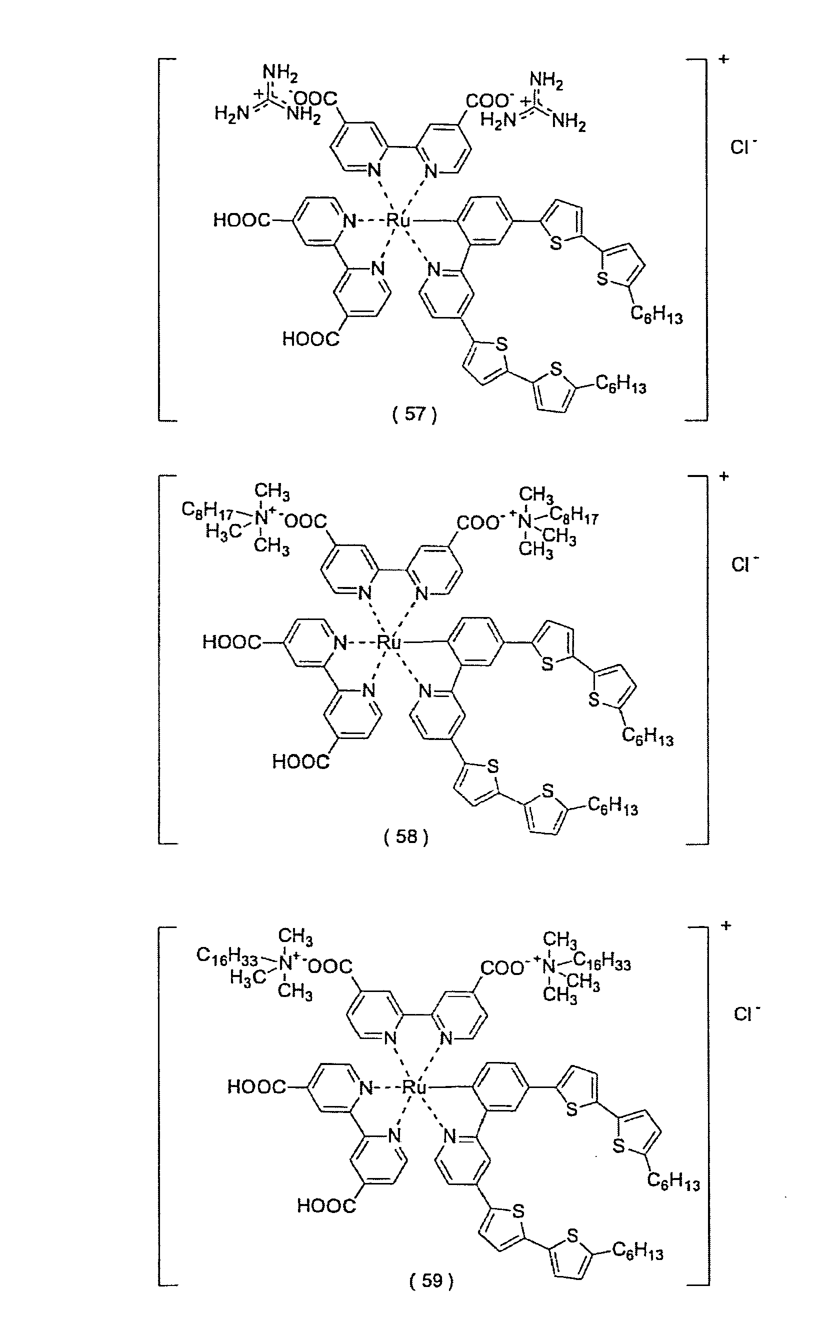

The pyridine type metal complex represented by the formula (13) can be represented by the general formulae (33) to (36) and, more specifically, it is preferably a metal complex represented by the formulae (60) to (67).

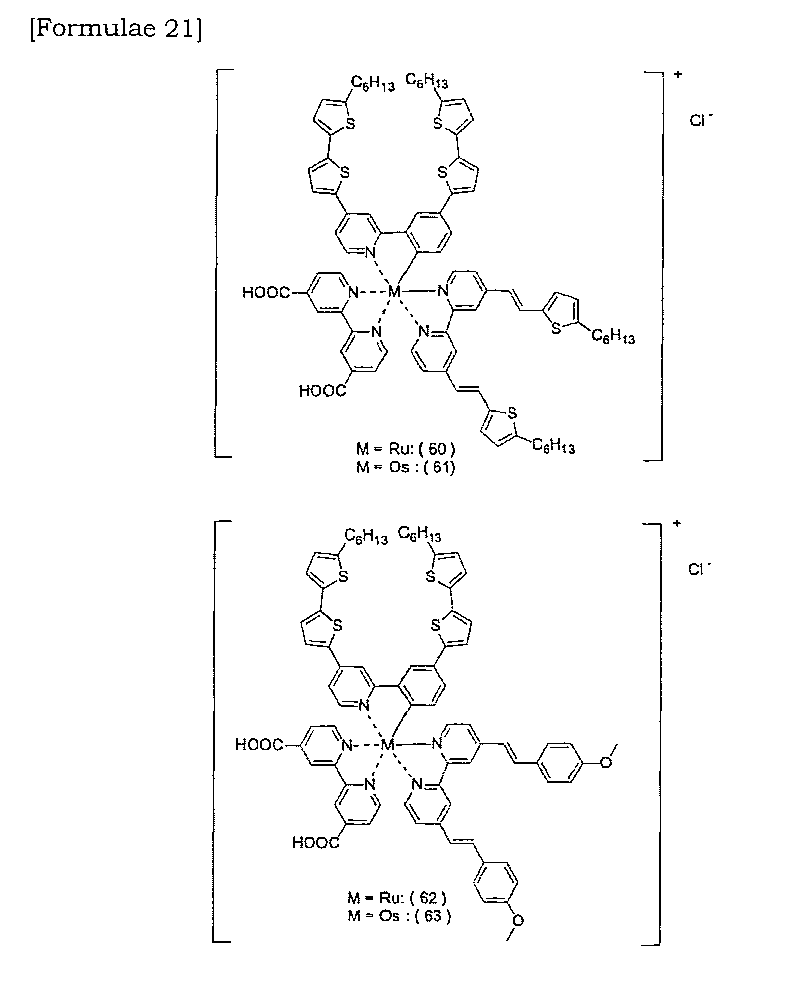

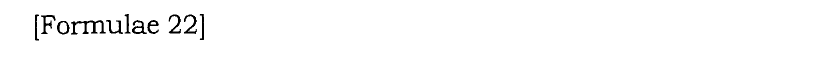

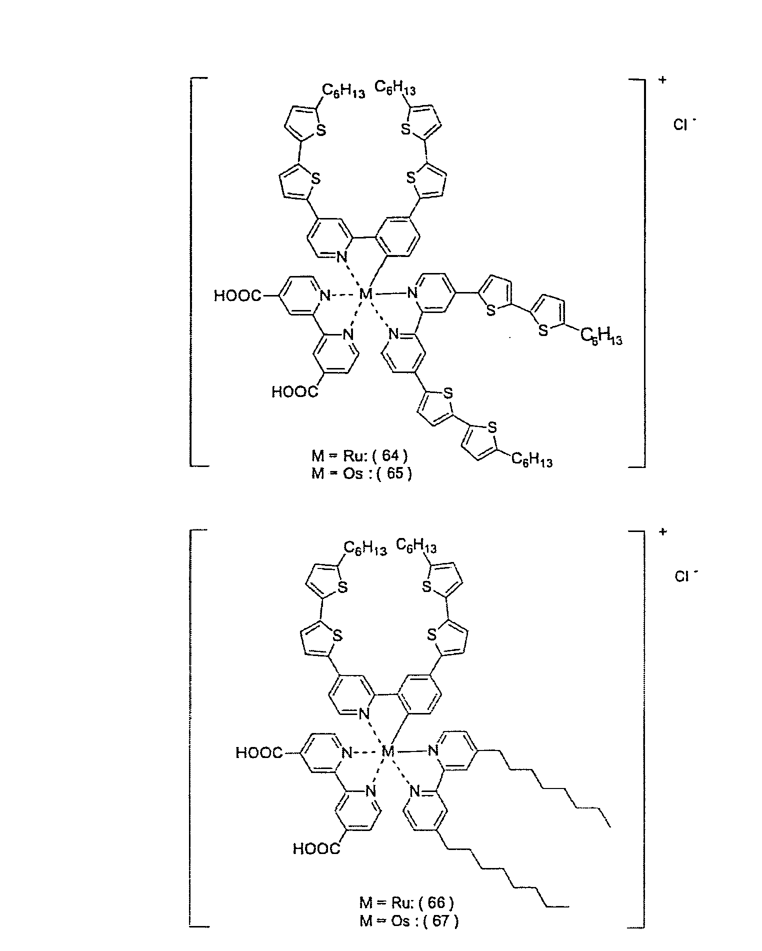

The pyridine type metal complex represented by the formula (14) can be represented by the general formulae (37) to (40) and, more specifically, it is preferably a metal complex represented by the formulae (68) to (70).

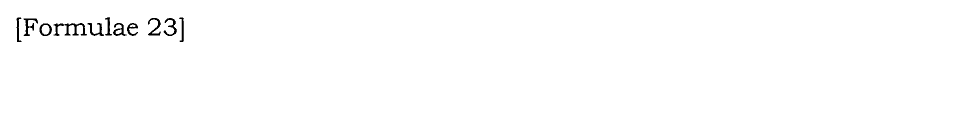

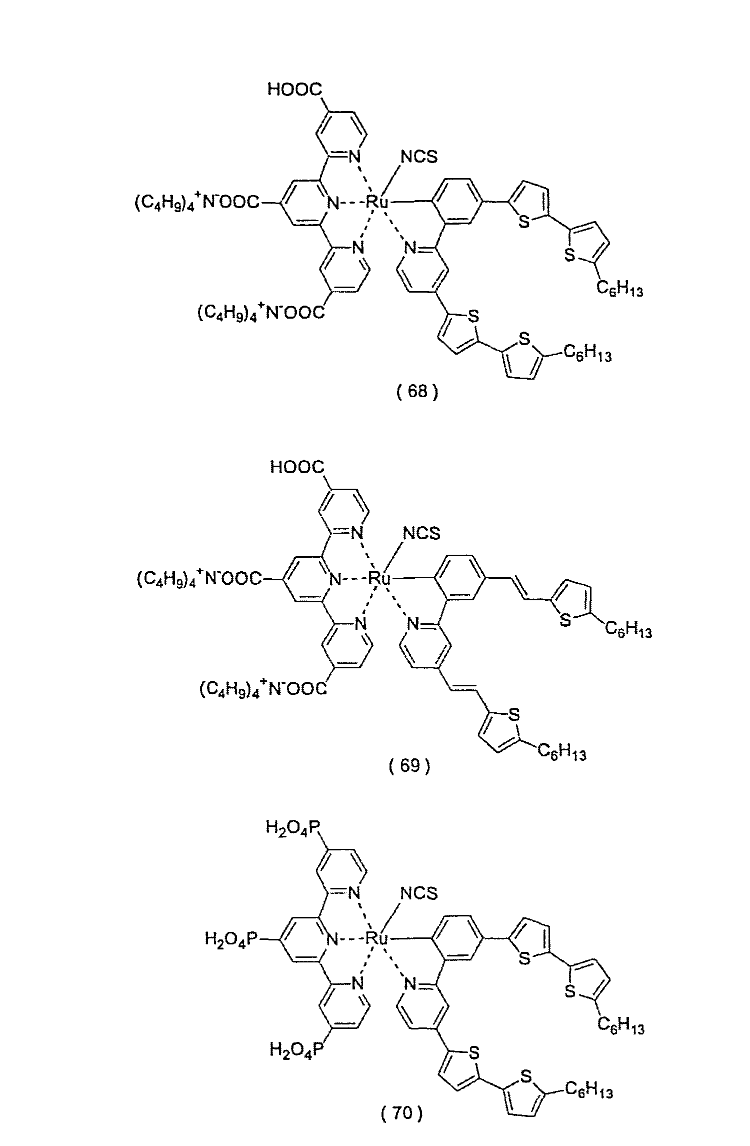

The pyridine type metal complex represented by the formula (15) can be represented by the general formulae (41) and (42) and, more specifically, it is preferably a metal complex represented by formulae (71) to (73).

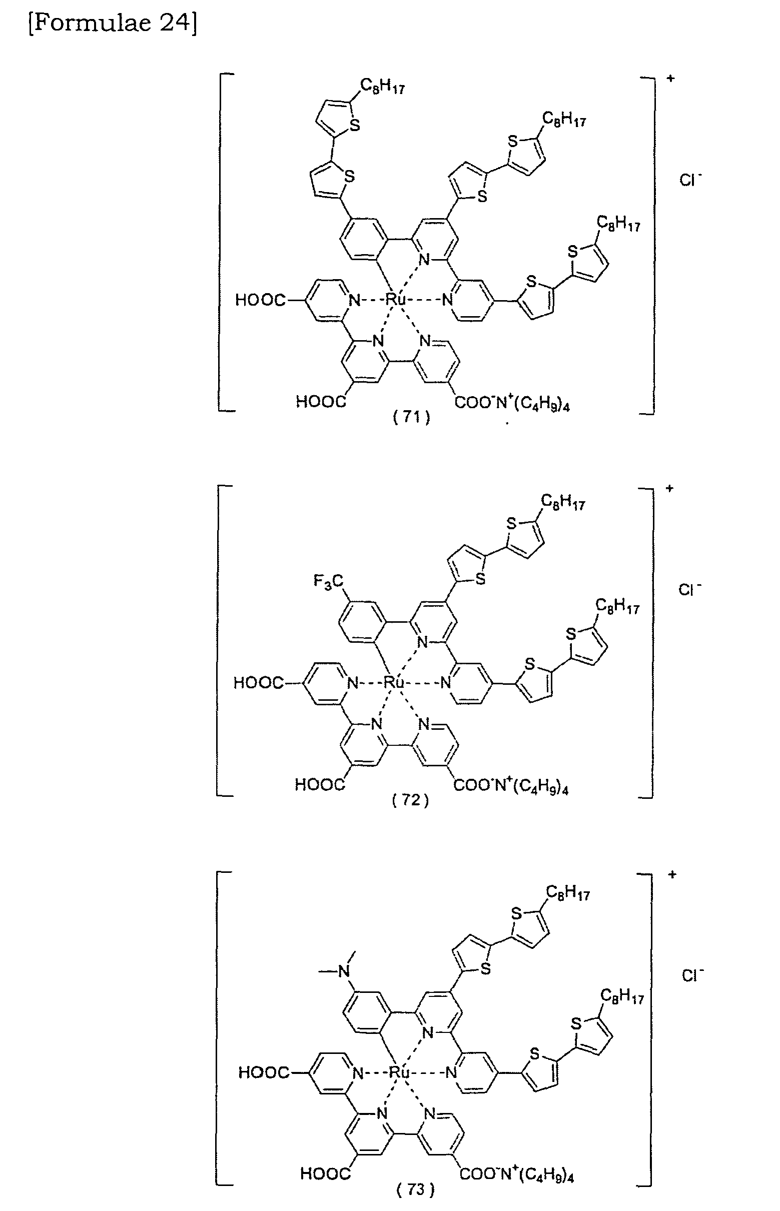

The photoelectrode of the present invention comprises adsorbing the above-mentioned pyridine type metal complex onto a surface of a semiconductor layer.
The semiconductor layer includes semiconductor fine particles and is generally formed on a conductive support. The layer is preferably in a form of a porous membrane but may be granular or a membrane.

A material of the semiconductor fine particles is not particularly limited as long as it can be used generally for a photoelectric conversion material and examples thereof include oxides such as titanium oxide, zinc oxide, tin oxide, iron oxide, niobium oxide, zirconium oxide, cerium oxide, silicon oxide, aluminum oxide, nickel oxide, tungsten oxide, barium titanate, strontium titanate, CuAlO₂ and SrCu₂O₂; and sulfides such as cadmium sulfide, lead sulfide, zinc sulfide, sulfides of indium phosphide or copper-indium (e.g. CuInS₂) and these compounds may be used alone or in combination.

Further, these semiconductors may be single crystals or polycrystals; however in terms of stability, difficulty of crystal growth and production cost, polycrystals are preferably.
Those commercialized can be used as the semiconductor fine particles and their average particle diameter is preferably about 1 to 1000 nm.

In terms of good stability and safety, among the above-mentioned semiconductor particles, particles including titanium oxide or tin oxide are preferable and particles including titanium oxide are particularly preferable.
Titanium oxide may include various types of narrowly-defined titanium oxide such as anatase type titanium oxide, rutile type titanium oxide, amorphous titanium oxide, metatitanic acid and orthotitanic acid, and also titanium hydroxide and hydrated titanium oxide.

The conductive support is not particularly limited as long as it has strength enough to form a semiconductor layer on its surface and may include a support made of a material having conductivity and a conductive or insulating support bearing a conductive film on its surface. In a case where light enters from a conductive support side, a transparent material may be used for the support and the conductive film.
Examples of the support made of a material having conductivity include a metal substrate such as copper or aluminum, and a substrate made of SnO₂ (tin oxide), ITO, CuI or ZnO.

Examples of the support bearing a conductive film on its surface include, in addition to the above-mentioned substrates, a glass substrate, a plastic substrate and a polymer sheet.
Examples of the polymer sheet include tetraacetyl cellulose (TAC), polyethylene terephthalate (PET), polyphenylene sulfide (PPS), polycarbonate (PC), polyarylate (PA), polyether imide (PEI) and a phenoxy resin.

Examples of the conductive film include a conductive material such as platinum, silver, copper, aluminum, indium, conductive carbon, ITO, SnO₂, CuI and ZnO, and the conductive film may be formed on each support by a known method such as a vapor phase method, e.g. a vacuum vapor deposition method, a sputtering method, a CVD method and a PVD method; and a coating method, e.g. a sol-gel method. A film thickness of these films is properly about 0.1 µm to 5 µm.

A method for forming the semiconductor layer on the conductive support is not particularly limited and the following known methods and their combination may be exemplified:
(1) a method of applying a suspension containing semiconductor particles to a conductive support, and drying and/or firing the suspension;
(2) a method such as a CVD method or a MOCVD method using a single gas or a mixed gas of two or more kinds of gases containing elements forming the semiconductor;
(3) a method such as a PVD method, a deposition method, or a sputtering method using a single solid substance or combinations of a plurality of solid substances or a solid of a compound containing elements forming the semiconductor as a raw material: and
(4) a sol-gel method or a method employing electrochemical redox reaction.

In the method (1), first, a suspension prepared by adding semiconductor particles and arbitrarily a dispersant to a solvent such as a glyme type solvent, e.g. ethylene glycol monomethyl ether, an alcohol type solvent, e.g. isopropyl alcohol, an alcohol type mixed solvent, e.g. isopropyl alcohol/ toluene, or water is applied to a conductive support. Examples of an application method include known methods such as a doctor blade method, a squeeze method, a spin coating method and a screen printing method. Thereafter, the coating solution is dried and fired to form the semiconductor layer.

Conditions such as temperature, period of time, and atmosphere for the drying and the firing may be appropriately set according to the kinds of the conductive material and semiconductor particles to be used. The firing may be carried out, for example, at a temperature of approximately 50°C to 800°C in atmospheric air or inert gas for approximately 10 seconds to 12 hours. The drying and the firing may be carried out at a constant temperature only once or at varied temperatures two or more times.

A thickness of the porous semiconductor layer is not particularly limited; however it is preferably about 0.1 to 50 µm in terms of light transmittance and photoelectric conversion efficiency. Further, in order to improve the photoelectric conversion efficiency, it is required to adsorb a large quantity of a dye in the porous semiconductor layer and therefore, the porous semiconductor is preferable to have a larger specific surface area as high as about 10 to 200 m²/g.

Examples of a method for adsorbing the pyridine type metal complex of the present invention onto the surface of the semiconductor layer include a method of immersing the semiconductor layer in a solution containing the complex (a solution for dye adsorption) and a method of applying the solution for dye adsorption to the semiconductor layer.

Specific examples of a solvent for dissolving the complex include organic solvents such as ethanol, toluene, acetonitrile, THF, chloroform and dimethylformamide. These solvents are generally preferably those refined and two or more of them may be used in form of a mixture. The concentration of the dye in the solvent can be determined according to conditions including the dye to be used, the kind of the solvent, adsorption process and the like, and it is preferably 1 × 10⁻⁵ mol/L or more.

Conditions of temperature, pressure, period of time in the process of immersing the porous semiconductor layer in the solution for dye adsorption may be appropriately set. The immersion may be carried out once or a plurality of times and after the immersion, drying may be appropriately carried out.
Before adsorption of a sensitizing dye in the porous semiconductor layer, a treatment for activating the surface of the semiconductor, for example, a treatment with TiCl₄ may be carried out if necessary.

The dye-sensitized solar cell of the present invention comprises the above-mentioned photoelectrode (photoelectric conversion device) and includes a carrier transporting layer between the above-mentioned photoelectrode (photoelectric conversion device) and a counter electrode.
As described above, the photoelectrode of the present invention is particularly preferably used for the dye-sensitized solar cell.

The counter electrode is not particularly limited as long as it is conductive and examples thereof include n-type or p-type element semiconductors (such as silicon and germanium) or compound semiconductors (such as GaAs, InP, ZnSe and CsS); metals such as gold, silver, copper and aluminum; high melting point metals such as titanium, tantalum and tungsten; monolayer or multilayered conductive films made of transparent conductive materials such as ITO, SnO₂, CuI and ZnO; and those having the same configuration as that of the above-mentioned conductive support.

These conductive films may be formed by a known method such as a vapor phase method, e.g. a vacuum vapor deposition method, a sputtering method, a CVD method and a PVD method; and a coating method, e.g. a sol-gel method. A film thickness of the films is properly about 0.1 µm to 5 µm.

Further, the counter electrode preferably has a protection layer made of platinum or the like on its surface.
The protection layer of platinum may be formed by a sputtering method or a method of thermal decomposition of chloroplatinic acid, or electrodeposition. A film thickness of the protection layer is properly about 1 nm to 1000 nm.

The carrier transporting layer includes a conductive material capable of transporting electrons, holes or ions. Examples thereof include hole transporting materials such as polyvinyl carbazole and triphenylamine; electron transporting materials such as tetranitroflorenone; conductive polymers such as polythiophene and polypyrrole; ion conductors such as liquid electrolytes and polymer electrolytes; and inorganic p-type semiconductors such as copper iodine and copper thiocyanate.

Among the above-mentioned conductive materials, the ion conductors are preferable and liquid electrolytes containing redox electrolytes are particularly preferable. Such a redox electrolyte is not particularly limited as long as it can be used commonly for batteries, solar cells and the like. Specific examples thereof include those containing I⁻/I³⁻ type, Br²⁻/Br³⁻ type, Fe²⁺/Fe³⁺ type and quinone/hydrodquinone type redox molecules. Examples of the redox molecules include combinations of iodine (I₂) with metal iodide such as lithium iodide (LiI), sodium iodide (NaI), potassium iodide (KI) or calcium iodide (CaI₂); combinations of iodine with a tetraalkylammonium salt such as tetraethylammonium iodide (TEAI), tetrapropylammonium iodide (TPAI), tetrabutylammonium iodide (TBAI) or tetrahexylammonium iodide (THAI); or combinations of bromine with a metal bromide such as lithium bromide (LiBr), sodium bromide (NaBr), potassium bromide (KBr) or calcium bromide (CaBr₂) and among these, the combination of LiI and I₂ is particularly preferable.

Examples of the solvent for the liquid electrolyte include carbonate compounds such as propylene carbonate; nitrile compounds such as acetonitrile; alcohols such as ethanol; as well as water and non-protonic polar substances and among these, carbonate compounds and nitrile compounds are particularly preferable. Two or more of these solvents may be used in form of a mixture.
The electrolyte concentration in the liquid electrolyte is preferably in a range of 0.1 mol/L to 1.5 mol/L and particularly preferably in a range of 0.1 mol/L to 0.7 mol/L.

An additive may be added to the liquid electrolyte. Herein, examples of the additive include nitrogen-containing aromatic compounds such as tert-butylpyridine (TBP), or imidazole salts such as dimethylpropylimidazole iodide (DMPII), methylpropylimidazole iodide (MPII), ethylmethylimidazole iodide (EMII), ethylimidazole iodide (EII) and hexylmethylimidazole iodide (HMII).

Further, examples of the polymer electrolytes include polymer compounds such as polyethylene oxide, polypropylene oxide, polyethylene succinate, poly-β-propiolactone, polyethyleneimine and polyalkylene sulfide and crosslinked compounds thereof; and adducts obtained by adding polyether segments or oligoalkylene oxide structures as side chains to polymer functional groups such as polyphosphazenes, polysiloxanes, polyvinyl alcohols, polyacrylic acid and polyalkylene oxides and copolymers thereof and among these, those having oligoalkylene oxide structures as side chains and those having polyether segments as side chains are preferable.

Fig. 1 is a schematic cross-sectional view showing one example of a layer structure of a dye-sensitized solar cell comprising a photoelectrode of the present invention.
The dye-sensitized solar cell comprises a conductive support 9 including a transparent conductive film 7 formed on an insulating substrate 8 as a support, a semiconductor layer including a plurality of semiconductor fine particles 6, a pyridine type metal complex 5 of the present invention adsorbed onto a surface of the semiconductor particles 6, a carrier transporting layer 4, and a counter electrode 12 obtained by successively forming a transparent conductive film 2 and a platinum layer 3 on an insulating substrate 1. Herein, a photoelectrode (photoelectric conversion device) 10 of the present invention is formed of the pyridine type metal complex 5 of the present invention and the semiconductor layer containing a plurality of semiconductor particles 6 and an electrode 11 including the photoelectric conversion device is formed of the photoelectrode 10 and the conductive support 9.

When sunlight enters in this dye-sensitized solar cell, the pyridine type metal complex 5 of the present invention absorbs the sunlight and is excited and electrons generated by the excitation are transferred to the semiconductor particles 6. Next, the electrons are transferred to the transparent conductive film 2 of the counter electrode 12 from the transparent conductive film 7 through an external circuit. Thereafter, the electrons pass from the transparent conductive film 2 through the platinum layer 3 to reduce the redox system in the carrier transporting layer 4.
On the other hand, the pyridine type metal complex 5 of the present invention from which the electrons are transferred to the semiconductor particles 6 becomes in a state of oxidized body and this oxidized body is reduced by the redox system in the carrier transporting layer 4 and is turned back to the original state. A flow of electrons in such a process continuously converts photo-energy into electric energy.

### Examples

The present invention will be further described in detail by way of Examples (including synthesis of complexes) and Comparative Examples; however it is not intended that the present invention be limited to these Examples.

### (Example 1)

### (1) Synthesis of ruthenium complex

### (a) Synthesis of 2-(2'-methylphenyl)-4-methylpyridine

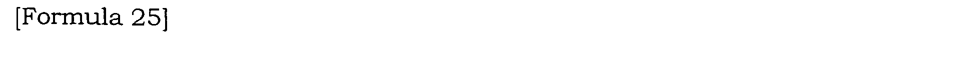

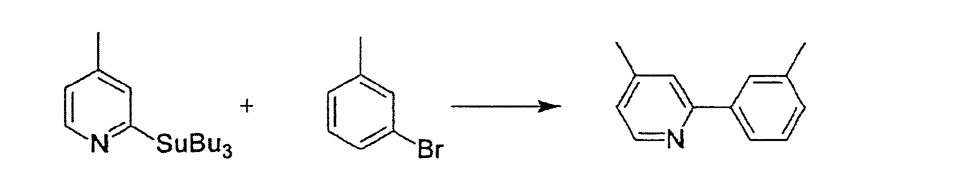

2-tributylstannylpyridine (6.02 g, 16.3 mmol), 1-bromo-2-methylbenzene (6.63 g, 38.8 mmol) and Pd(PPh₃)₄ (0.613 g, 0.003 equivalent) were refluxed in toluene (150 mL) and under an argon atmosphere for 72 hours. Next, the obtained solution was cooled to room temperature, the reaction system was concentrated, 6M-HCl (50 ml) was added, and extraction with methylene chloride (100 mL) was carried out three times to remove components such as raw materials and pyridyl derivatives as byproducts. Successively, an aqueous ammonium solution (28%) was added to the obtained water phase to neutralize the water phase. Continuously, an excess amount of NiCl₂-6H₂O was added to the obtained solution and extraction with methylene chloride (100 mL) was carried out three times to obtain a brown solution. Next, the obtained brown solution was dried with Na₂SO₄ and filtered with filter paper and the filtrate was concentrated under reduced pressure to obtain a brown oily product. Furthermore, the brown oily product was refined with a silica gel column (ethyl acetate) to obtain a finally aimed compound; 2-(2'-methylphenyl)-4-methylpyridine (2.0 g, 10.7 mmol) (yield: 66%).

### (b) Synthesis of ligand represented by formula (44)

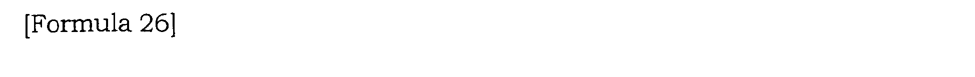

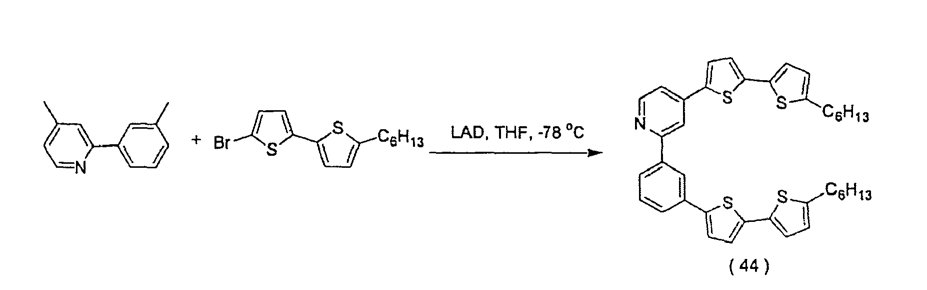

Under an argon atmosphere, a solution of 2.0 M-lithium diisopropylamide (LDA) in THF (9 mL, 18 mmol) was slowly added dropwise to a solution of 2-(2'-methylphenyl)-4-methylpyridine (1.5 g, 8.15 mmol) in anhydrous THF (80 mL, -78°C). Next, after the obtained reaction system was stirred at -78°C for 30 minutes, a solution of 2-bromo-5-(5-hexylthiophene-2-yl)thiophen (5.89 g, 17.9 mmol) in THF (50 mL) was added and the mixture was further stirred for 6 hours and then the reaction system was heated to room temperature. Successively, water (100 mL) and dichloromethane (200 mL) were added to the obtained reaction system to carry out phase separation. The obtained organic layer product was refined by an aluminum column (dichloromethane) to obtain a ligand represented by the formula (44) (yield 60%).

### (c) Synthesis of ruthenium complex represented by formula (50)

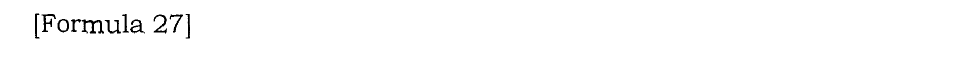

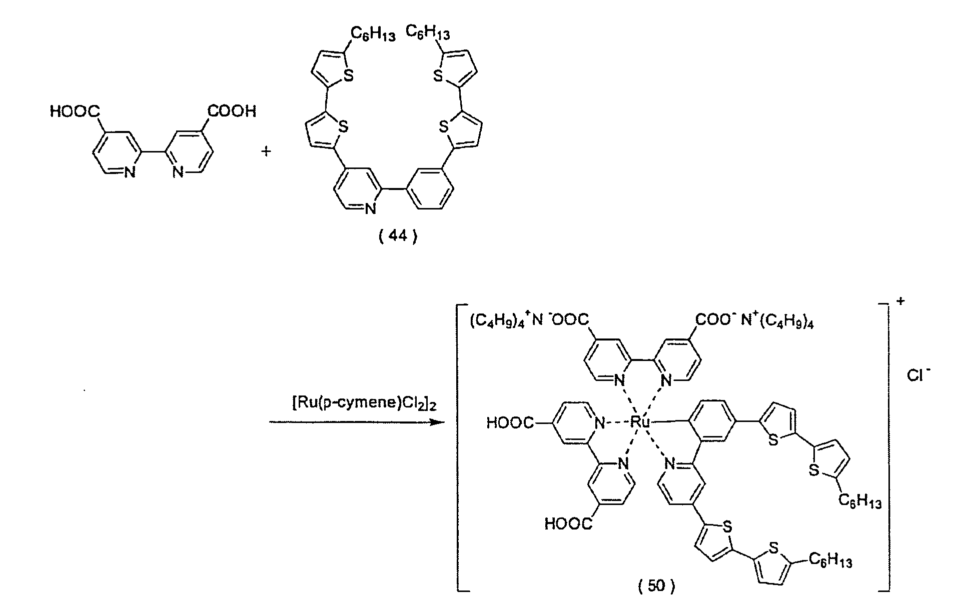

[Ru(p-cumene)Cl_{2]2} (21.6 mg, 0.035 mmol) was added to a solution of 4,4'-dicarboxy-2,2'-bipyridine (34.2 mg, 0.14 mmol) in DMF and the reaction system was refluxed for 4 hours. Next, the ligand (227.0 mg, 0.35 mmol) represented by the formula (44) was added to the obtained reaction system and further refluxed for 24 hours. The obtained reaction system was refined by a column (Sephadex LH-20) (methanol) to obtain a ruthenium complex represented by the formula (50) (yield: 48%).

Analysis results were as follows.
C₉₅H₁₂₆ClN₇O₈RuS₄:
Calculated value: C 64.87; H 7.22; N 5.57
Experimental value: C 64.86; H 7.23; N 5.45
MS (ESIMS): m/z: 1723 (M-Cl)

### (2) Production of electrode containing photoelectric conversion device and dye-sensitized solar cell

A dye-sensitized solar cell shown in Fig. 1 was produced.
A commercialized titanium oxide paste (manufactured by Nippon Aerogel; trade name: P25) was applied by a doctor blade method to a glass plate (manufactured by Nippon Sheet Glass Co., Ltd.; corresponding to conductive support 9) which is a transparent substrate (insulating substrate 8) on which a SnO₂ film as a transparent conductive film 7 was deposited. After the paste was preliminarily dried at 400°C for 10 minutes, it was dried at 500°C for 2 hours to form a titanium oxide film (a layer of semiconductor particles 7) with a thickness of 10 µm.

Next, the ruthenium complex (corresponding to pyridine type metal complex 5) represented by the formula (50), which was obtained in (1), was dissolved in ethanol so as to be a concentration of 2×10⁻⁴ mol/L to obtain a solution for dye adsorption. The above-mentioned glass plate on which the titanium oxide film was formed was immersed in the obtained solution for dye adsorption to adsorb the ruthenium complex as a sensitizing dye onto titanium oxide particles (semiconductor particles 7) of the titanium oxide film to obtain an electrode 11 containing the photoelectrode (dye-sensitized oxide semiconductor electrode).

A platinum layer 3 with a film thickness of 300 nm was formed by deposition on a glass plate (corresponding to insulating substrate 1) having a transparent conductive film 2 with the same configuration as that of the above-mentioned glass plate to obtain a counter electrode 12.
An electrolyte solution as a carrier transporting layer was injected between the dye-sensitized oxide semiconductor electrode and the counter electrode and their side faces were sealed with a resin to form a carrier transporting layer 4. As the electrolyte solution, a solution obtained by dissolving LiI (0.1 M, manufactured by Aldrich), I₂ (0.05 M, manufactured by Aldrich), tert-butylpyridine (0.5 M, manufactured by Aldrich) and dimethylpropylimidazolium iodide (0.6 M, manufactured by Shikoku Chemicals Corporation) in acetonitrile (manufactured by Aldrich). Thereafter, lead wires were connected to each electrode to obtain a dye-sensitized solar cell.

### (Example 2)

### (1) Synthesis of ruthenium complex

### (a) Synthesis of bipyridine ligand represented by formula (45)

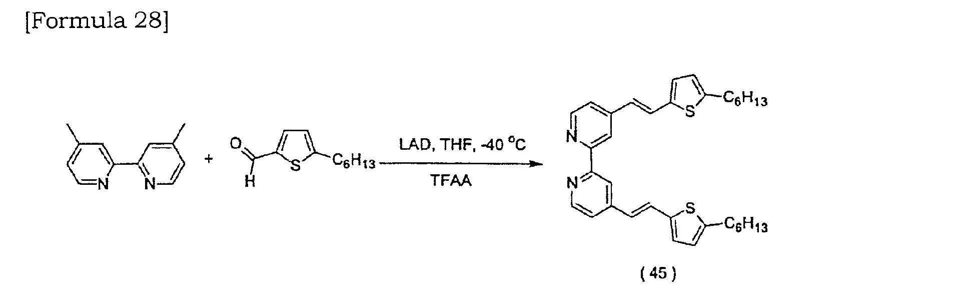

Under an argon atmosphere, a solution of 2.0 M-lithium diisopropylamide (LDA) in THF (2.5 mL, 5 mmol) was slowly added dropwise to a solution of 4,4-dimethylbipyridine (0.5 g, 2.48 mmol) in anhydrous THF (80 mL, -78°C). Next, after the obtained reaction system was stirred at -40°C for 30 minutes, a solution of a thiophene ligand (0.98 g, 5.0 mmol) in THF (50 mL) was added and the mixture was further stirred for 6 hours and then the reaction system was heated to room temperature. Successively, water (100 mL) and dichloromethane (200 mL) were added to the obtained reaction system to carry out phase separation. The obtained organic layer product was dissolved in dichloromethane (100 mL) and trifluoroacetic anhydride (TFAA, 2 mL, 14.3 mmol) was added thereto and the mixture was allowed to react for 12 hours. The obtained product was refined by an aluminum column (dichloromethane) to obtain a bipyridine ligand represented by the formula (45) (yield 53%).

### (b) Synthesis of ruthenium complex represented by formula (60)

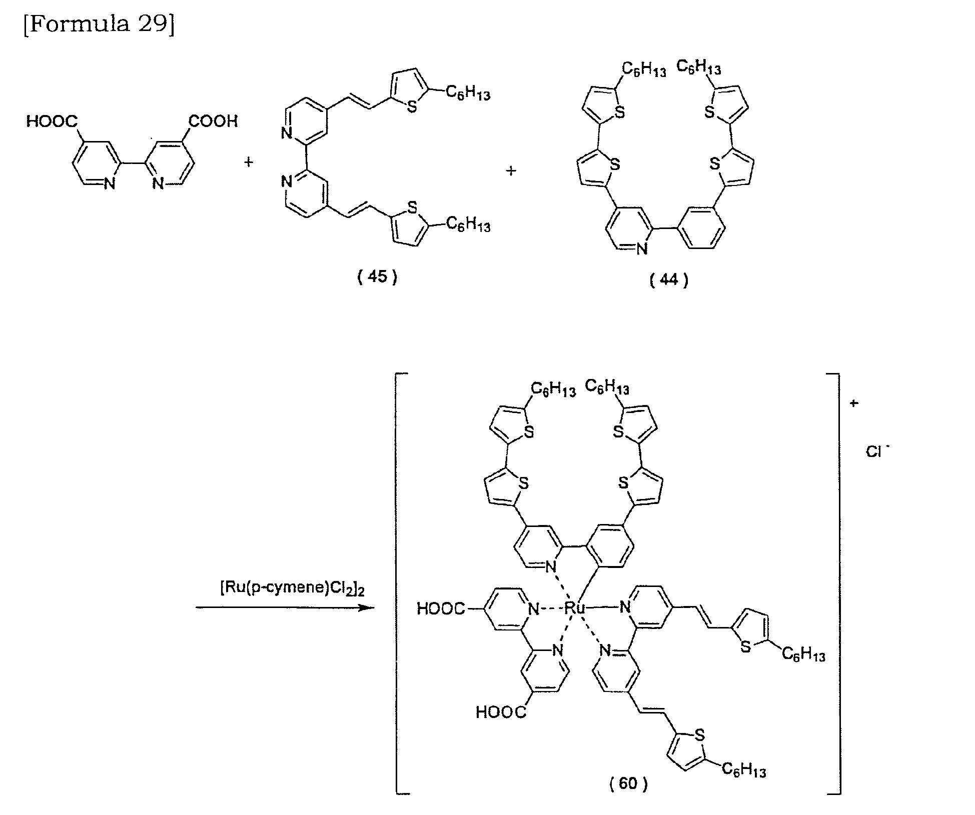

The ligand (36.9 mg, 0.07 mmol) represented by the formula (45) was added to a solution of [Ru(p-cumene)Cl₂]₂ (21.6 mg, 0.035 mmol) in DMF and the reaction system was refluxed for 4 hours. Next, 4,4'-dicarboxy-2,2'-bipyridine (17.1 mg, 0.07 mmol) was added to the obtained reaction system and further refluxed for 4 hours. Finally, the ligand (227.0 mg, 0.35 mmol) represented by the formula (44) was added to the obtained reaction system and the mixture was further refluxed for 24 hours. Refining was carried out using a column (Sephadex LH-20) (methanol) to obtain a ruthenium complex represented by the formula (60) (yield: 37%).

Analysis results were as follows.
C₈₅H₈₈ClN₅O₄RuS₆:
Calculated value: C 64.92; H 5.64; N 4.45
Experimental value: C 64.90; H 5.74; N 4.46
MS (ESIMS): m/z: 1536 (M-Cl)

### (2) Production of electrode containing photoelectric conversion device and dye-sensitized solar cell

An electrode containing a photoelectric conversion device and a dye-sensitized solar cell were produced in the same manner as in Example 1, except that the ruthenium complex represented by the formula (60), which was obtained in (1), was used in place of the ruthenium complex represented by the formula (50).

### (Example 3)

### (1) Synthesis of ruthenium complex

### (a) Synthesis of ruthenium complex represented by formula (68)

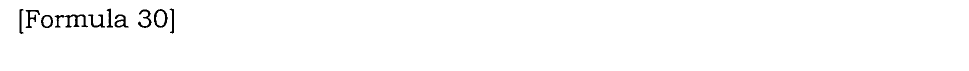

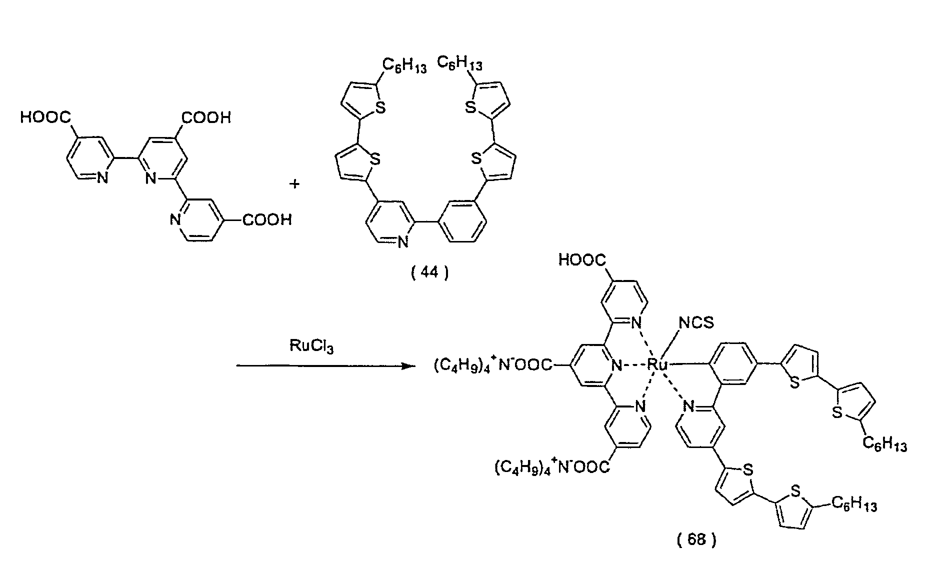

RuCl₂ (14.5 mg, 0.07 mmol) was added to a solution of tricarboxyterpyridine (25.6 mg, 0.07 mmol) in DMF and the obtained reaction system was refluxed for 4 hours. Next, the ligand (227.8 mg, 0.35 mmol) represented by the formula (44) was added to the obtained reaction system and the mixture was refluxed further for 24 hours. Finally, N(C₄H₉)₄NCS (105.2 mg, 0.35 mmol) was added to the obtained reaction system and the mixture was refluxed for 24 hours. Refining was carried out using a column (Sephadex LH-20) (methanol) to obtain a ruthenium complex represented by the formula (68) (yield: 55%).

Analysis results were as follows.
C₉₀H₁₂₁N₇O₆RuS₅:
Calculated value: C 65.18; H 7.35; N 5.91
Experimental value: C 65.10; H 7.30; N 5.89
MS (ESIMS): m/z: 1658 (M)

### (2) Production of electrode containing photoelectric conversion device and dye-sensitized solar cell

An electrode containing a photoelectric conversion device and a dye-sensitized solar cell were produced in the same manner as in Example 1, except that the ruthenium complex represented by the formula (68), which was obtained in (1), was used in place of the ruthenium complex represented by the formula (50).

### (Example 4)

### (1) Synthesis of ruthenium complex

### (a) Synthesis of ligand represented by formula (46)

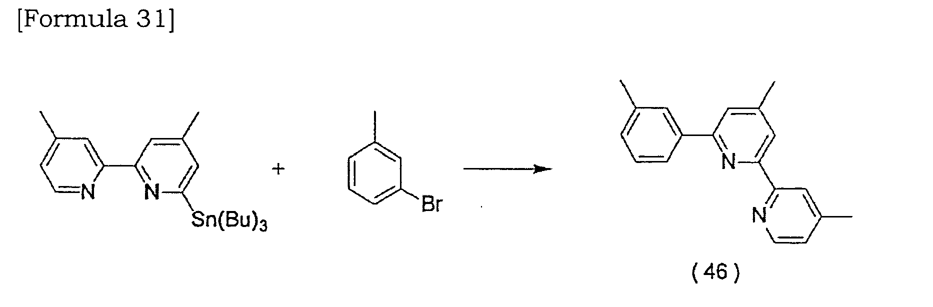

A ligand represented by the formula (46) was obtained in the same manner as in (1) (a) of Example 1, except that
6-tributylstannyl-4,4'-dimethyl-2,2'-bipyridine was used in place of 2-tributylstannylpyridine (yield: 65%).

### (b) Synthesis of ligand represented by formula (47)

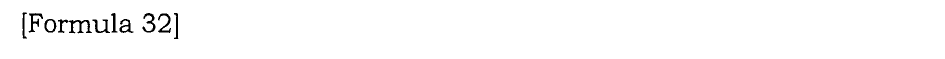

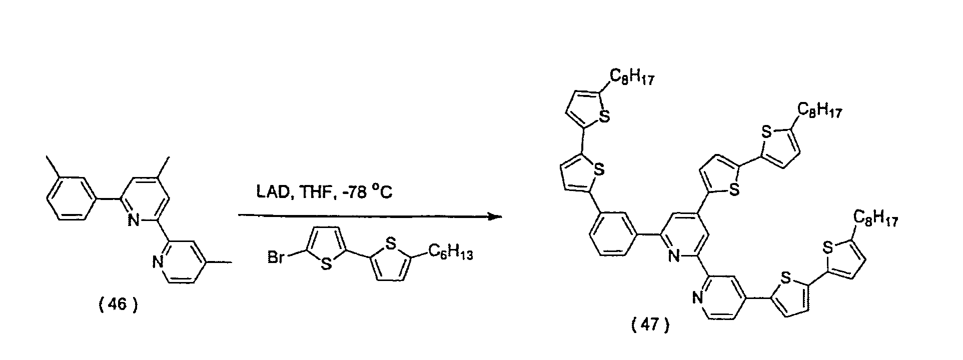

A ligand represented by the formula (47) was obtained in the same manner as in (1) (b) of Example 1, except that the ligand represented by the formula (44) was used in place of 2-(2-bismethylphenyl)pyridine (yield: 53%).

### (b) Synthesis of metal complex represented by formula (71)

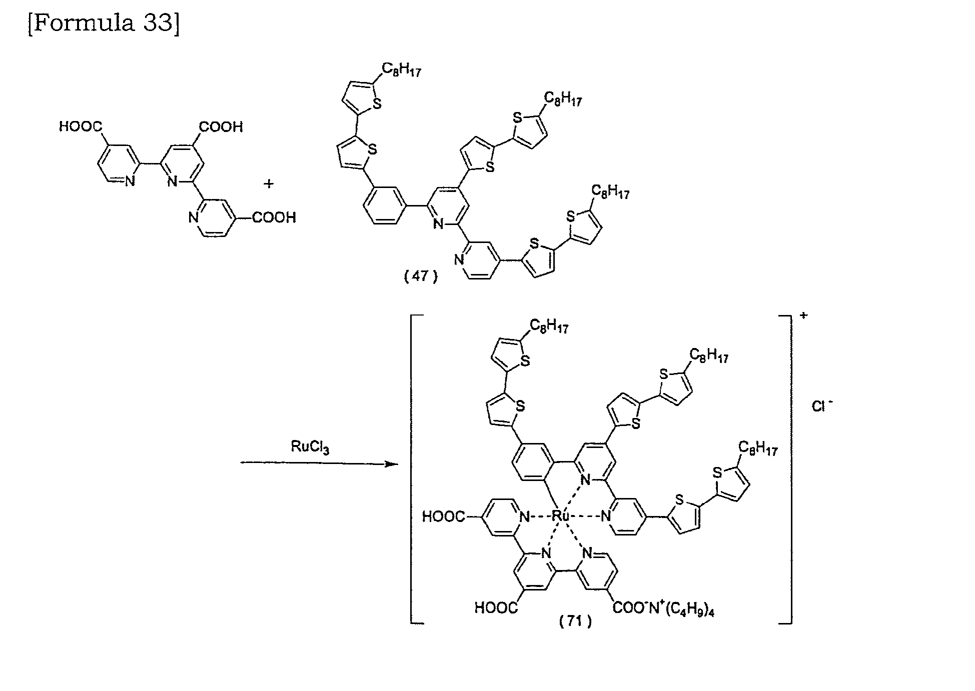

A metal complex represented by the formula (71) was obtained in the same manner as in (1) (c) of Example 1, except that the ligand represented by the formula (45) was used in place of the ligand represented by the formula (44) (yield: 53%).

Analysis results were as follows.
C₉₈H₁₁₇ClN₆O₆RuS₆:
Calculated value: C 65.25; H 6.54; N 4.66
Experimental value: C 66.23; H 6.50; N 4.73
MS (ESIMS): m/z: 1767 (M-Cl)

### (2) Production of electrode containing photoelectric conversion device and dye-sensitized solar cell

An electrode containing a photoelectric conversion device and a dye-sensitized solar cell were produced in the same manner as in Example 1, except that the ruthenium complex represented by the formula (71), which was obtained in (1), was used in place of the ruthenium complex represented by the formula (50).

### (Comparative Example)

An electrode containing a photoelectric conversion device and a dye-sensitized solar cell were produced in the same manner as in Example 1, except that a so-called Black Dye complex (4,4',4"-tricarboxy-2,2':6',2"-terpydidine ruthenium complex) represented by the following formula, which was described in B. Durhum, S. R. Wilson, D. J. Hodgers, T. J. Meyer, J. Am. Chem. Soc., 123, 1613 (2001), was used in place of the ruthenium complex represented by the formula (50).

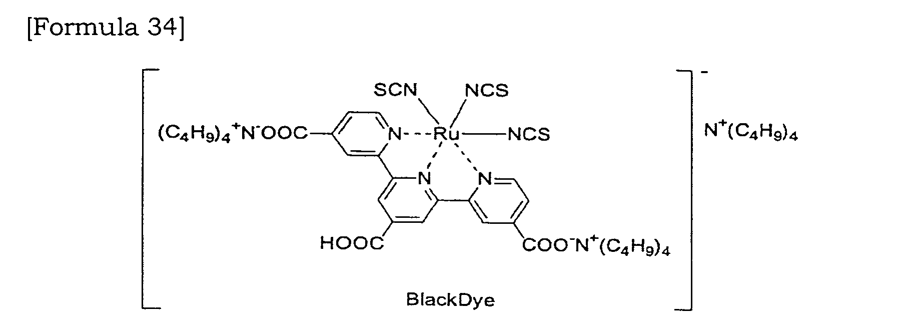

### (Test for battery properties)

The respective dye-sensitized solar cells obtained in Examples 1 to 4 and Comparative Example 1 were subjected to a test for battery properties. Specifically, each dye-sensitized solar cell was irradiated with artificial sunlight of 100 mV/cm² from a xenon lamp through an AM filter (AM-1.5) using a solar simulator (manufactured by Wacom Electric Co., Ltd., Model: WXS-155S-10) and a current-voltage characteristic of each dye-sensitized solar cell was measured using an I-V tester to determine the open circuit voltage Voc (V), short-circuit current Jsc (mA/cm²), fill factor F. F. and photoelectric conversion efficiency η (%) at immediately after starting operation. The obtained results are shown in Table 1.

**[Table 1]**

| | Short-circuit current Jsc (mA/cm²) | Open circuit voltage Voc (V) | Fill factor F. F | Photoelectric conversion efficiency η (%) |
|---|---|---|---|---|
| Example 1 | 17.1 | 0.746 | 0.701 | 8.9 |
| Example 2 | 18.9 | 0.698 | 0.704 | 9.3 |
| Example 3 | 17.9 | 0.740 | 0.710 | 9.4 |
| Example 4 | 19.0 | 0.720 | 0.704 | 9.6 |
| Comparative Example 1 | 18.8 | 0.706 | 0.694 | 9.2 |

### (Stability)

The stability of each dye-sensitized solar cell obtained in Examples 1 to 4 and Comparative Example 1 was evaluated. Specifically, using the above-mentioned solar simulator, the photoelectric conversion efficiency η (%) of each dye-sensitized solar cell was determined after continuous light irradiation for 500 hours to the dye-sensitized solar cell. The retention ratio (%) of the photoelectric conversion efficiency η (%) when the photoelectric conversion efficiency η (%) previously measured before the continuous light irradiation was set to 100% was determined as the stability (retention ratio) (%) to light.

An ethanol solution (concentration of 2×10⁻⁴ mol / L) of each of the ruthenium complexes represented by the formulae (50), (60), (68) and (71) used in Examples 1 to 4 and the Black Dye complex used in Comparative Example 1 was prepared and the maximum absorbance index of each solution was measured after the solution was held at a temperature of 80°C for 100 hours. The retention ratio (%) of the existence ratio (%) of the maximum absorbance index of each solution when the maximum absorbance index previously measured before the storage was set to 100% was determined as the stability (retention ratio) (%) to the heat.
The obtained results are shown in Table 2, together with the metal complexes used.

**[Table 2]**

| | Photoelectric conversion efficiency η (%) | Stability to light (retention ratio) (%) | Stability to heat (retention ratio) (%) | Used metal complex |
|---|---|---|---|---|
| Example 1 | 9.4 | 97 | 100 | Formula (50) |
| Example 2 | 9.3 | 98 | 99 | Formula (60) |
| Example 3 | 8.9 | 93 | 95 | Formula (68) |
| Example 4 | 8.9 | 95 | 100 | Formula (71) |
| Comparative Example 1 | 9.2 | 83 | 92 | BlackDye |

From the results shown in Table 1, it can be understood that each of the dye-sensitized solar cells of Examples 1 to 4 has a photoelectric conversion efficiency η which is almost the same as that of the dye-sensitized solar cell of Comparative Example 1.
Further, from the results shown in Table 2, it can be understood that the ruthenium complexes represented by the formulae (50), (60), (68) and (71) used in Examples 1 to 4 were more excellent in the heat stability than the Black Dye complex used in Comparative Example 1.
That is, it can be understood that a dye-sensitized solar cell comprising a photoelectrode containing the pyridine type metal complex of the present invention adsorbed onto a semiconductor layer has a photoelectric conversion efficiency which is almost the same as that of a dye-sensitized solar cell comprising a conventional dye and has excellent stability to light and heat.

The embodiments, synthesis examples and Examples disclosed herein are illustrative in all aspects and should not be considered as being limited. The scope of the present invention is not shown by the above description but is shown by the claims, and is intended to include all alterations in the claims and the meaning and scope of equivalents.

### DESCRIPTION OF THE REFERENCE NUMERALS

1. Insulating substrate
2. Transparent conductive film
3. Platinum layer
4. Carrier transporting layer
5. Pyridine type metal complex
6. Semiconductor particles
7. Transparent conductive film
8. Insulating substrate
9. Conductive support
10. Photoelectrode (photoelectric conversion device)
11. Electrode containing photoelectrode
12. Counter electrode

## Claims

1. A pyridine type metal complex having a partial structure represented by the formula (I) or (I'): 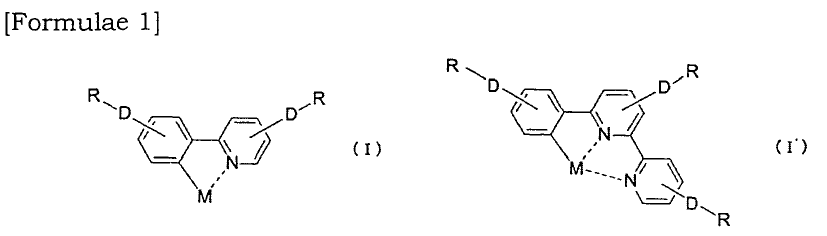 wherein,
M is a transition metal atom;
Ds, which may be the same or different, respectively represent any one of conjugated chains represented by structural formulae (2) to (11), 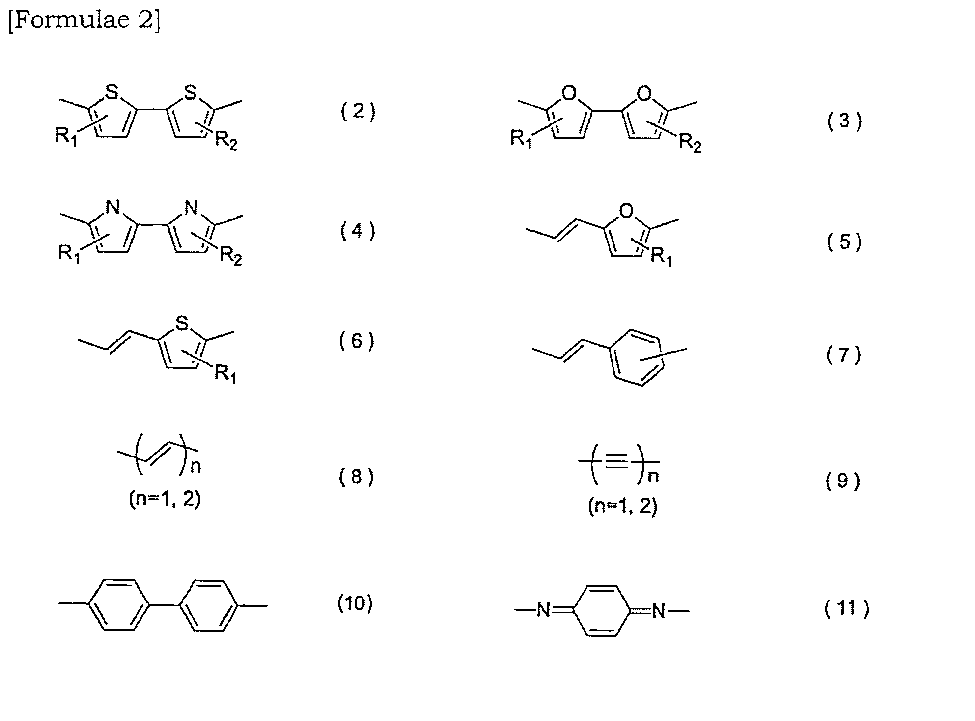 wherein R₁ and R₂, which may be the same or different, respectively represent an alkyl group having 1 to 20 carbon atoms;
Rs, which may be the same or different, respectively represent a halogen atom, a hydrogen atom, or an alkyl group having 1 to 20 carbon atoms, an alkenyl or alkynyl group having 2 to 10 carbon atoms, an aryl or heteroaryl group having 6 to 10 carbon atoms or an arylalkyl or heteroarylalkyl group having 7 to 13 carbon atoms which may have a substituent group.

2. A pyridine type metal complex according to claim 1,
wherein the pyridine type metal complex having a partial structure represented by the formula (I) or (I') represented by
the formula (12): ML₁(L₄)₂;
the formula (13): ML₁L₃L₄;
the formula (14): ML₁L₅X or
the formula (15): ML₂L₅;
wherein
L₁ represents a phenylpyridyl ligand;
L₂ represents a phenylbipyridyl ligand;
L₃ represents a substituent group (D-R-) described in claim 1 or a bidentate pyridyl ligand including an alkyl group having 1 to 20 carbon atoms, an alkenyl or alkynyl group having 2 to 10 carbon atoms, an aryl or heteroaryl group having 6 to 10 carbon atoms, or an arylalkyl or heteroarylalkyl group having 7 to 13 carbon atoms which may have a substituent group;
L₄ represents a bidentate pyridyl ligand having a carboxyl group, a sulfonic acid group, a hydroxyl group, a hydroxamic acid group, a phosphoryl group, or a phosphonyl group and two L₄ in the formula (12) are the same or different; and
L₅ represents a tridentate pyridyl ligand having a carboxyl group, a sulfonic acid group, a hydroxyl group, a hydroxamic acid group, a phosphoryl group, or a phosphonyl group;
X represents a monodentate ligand coordinated with a group selected from acyloxy, acylthio, thioacyloxy, thioacylthio, acylaminoxy, thiocarbamate, dithiocarbamate, thiocarbonate, dithiocarbonate, trithiocarbonate, acyl, thiocyanate, isothiocyanate, cyanate, isocyanate, cyano, alkylthio, arylthio, alkoxy and aryloxy, or a monodentate ligand including a halogen atom, carbonyl, dialkyl ketone, 1,3-diketone, carbonamide, thiocarbonamide, thiourea, or isothiourea; and
M is a metal atom of Ru, Fe, Os, Cu, W, Cr, Mo, Ni, Pd, Pt, Co, Ir, Rh, Re, Mn or Zn.

3. A pyridine type metal complex according to claim 2,
wherein the phenylpyridyl ligand for L₁ and the phenylbipyridyl ligand for L₂ are ligands derived from the formulae (16) and (17), respectively: 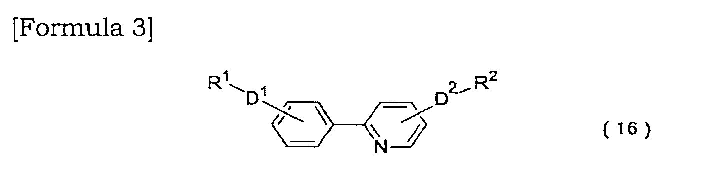 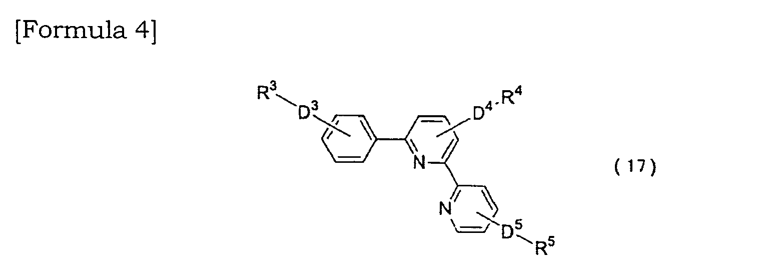 wherein
D¹, D², D³, D⁴ and D⁵, which may be the same or different, respectively represent any one of conjugated chains represented by the structural formulae (2) to (11) described in claim 1 and D¹ and D² in the formula (16) and D³, D⁴ and D⁵ in the formula (17) are the same or different,
R¹, R², R³, R⁴ and R⁵, which may be the same or different, respectively represent a halogen atom, a hydrogen atom, or an alkyl group having 1 to 20 carbon atoms, an alkenyl or alkynyl group having 2 to 10 carbon atoms, an aryl or heteroaryl group having 6 to 10 carbon atoms, or an arylalkyl or heteroarylalkyl group having 7 to 13 carbon atoms which may have a substituent group.

4. A pyridine type metal complex according to claim 2, wherein the bidentate pyridyl ligand for L₃ is a ligand derived from the formula (18): 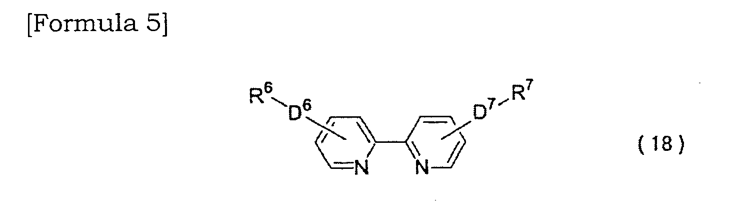 wherein
D⁶ and D⁷, which may be the same or different, respectively represent any one of conjugated chains represented by the structural formulae (2) to (11) described in claim 1 and D⁶ and D⁷ in the formula (18) are the same or different respectively;
R⁶ and R⁷, which may be the same or different, respectively represent a halogen atom, a hydrogen atom, or an alkyl group having 1 to 20 carbon atoms, an alkenyl or alkynyl group having 2 to 10 carbon atoms, an aryl or heteroaryl group having 6 to 10 carbon atoms, or an arylalkyl or heteroarylalkyl group having 7 to 13 carbon atoms which may have a substituent group.

5. A pyridine type metal complex according to claim 2,
wherein the bidentate pyridyl ligand for L₄ is selected from ligands derived from the following formulae (19) to (22).

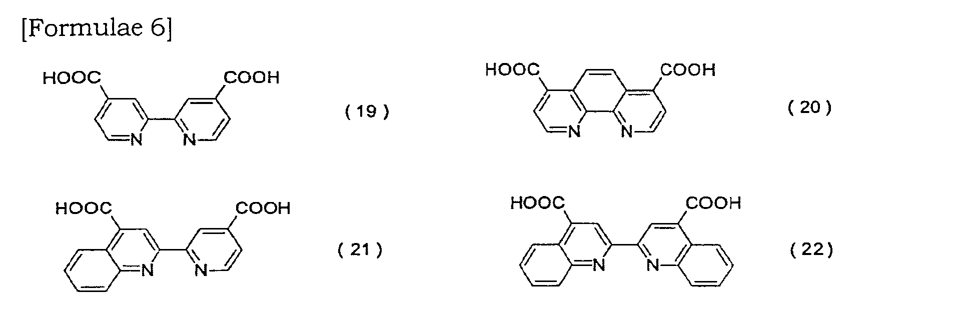

6. A pyridine type metal complex according to claim 2,
wherein the tridentate pyridyl ligand for L₅ is selected from ligands derived from the following formulae (23) to (28).

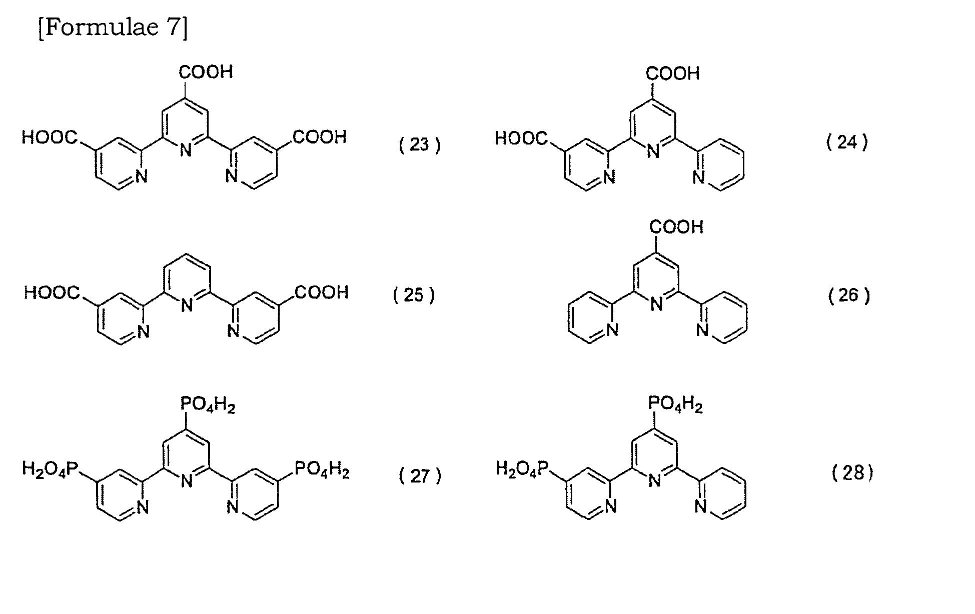

7. A pyridine type metal complex according to claim 2, wherein the pyridine type metal complex represented by the formula (12) is selected from the following formulae (29) to (32): 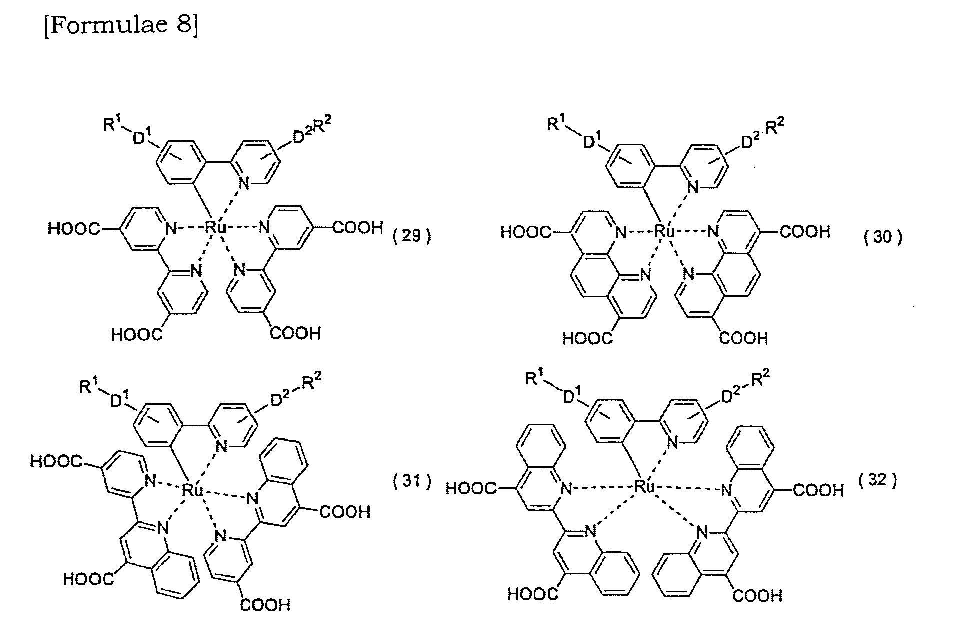 wherein D¹, D², R¹ and R²are the same as those defined in formula (16) of Claim 3.

8. A pyridine type metal complex according to claim 7, wherein the pyridine type metal complex represented by the formula (12) is represented by the formula (29)

9. A pyridine type metal complex according to claim 2, wherein the pyridine type metal complex represented by the formula (13) is selected from the following formulae (33) to (36): 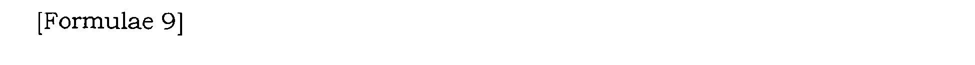 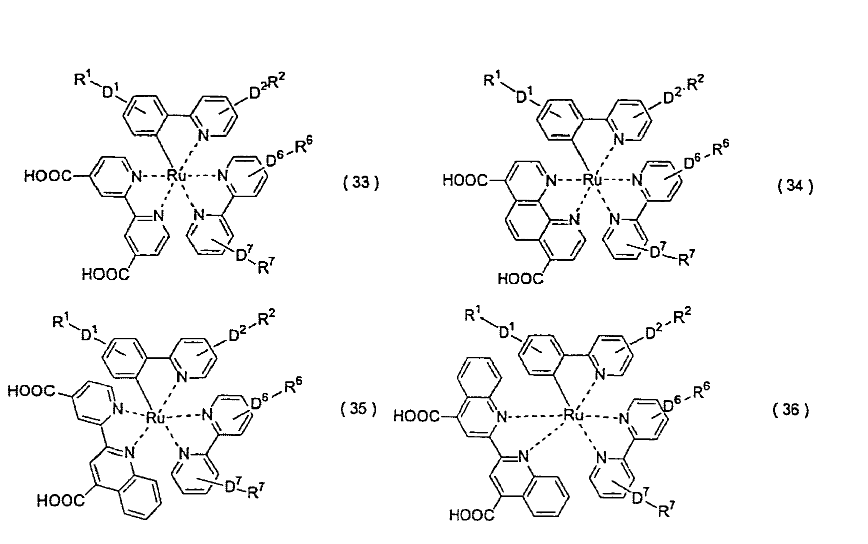 whrein D¹, D², R¹ and R² are the same as those defined in formula (16) of Claim 3, and D⁶, D⁷, R⁶ and R⁷are the same as those defined in formula (18) of Claim 4.

10. A pyridine type metal complex according to claim 9, wherein the pyridine type metal complex represented by the formula (13) is represented by the formula (33).

11. A pyridine type metal complex according to claim 2, wherein the pyridine type metal complex represented by the formula (14) is selected from the following formulae (37) to (40): 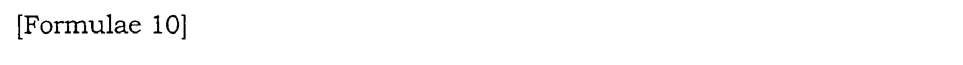 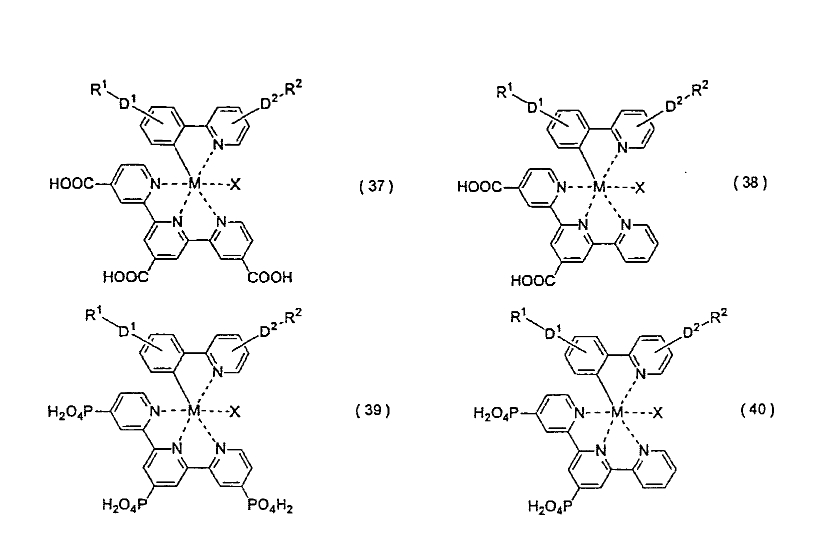 wherein D¹, D², R¹ and R²are the same as those defined in formula (16) of Claim 3, and X is the same as those defined in Claim 2.

12. A pyridine type metal complex according to claim 11, wherein the pyridine type metal complex represented by the formula (14) is represented by the formula (37).

13. A pyridine type metal complex according to claim 2, wherein the pyridine type metal complex represented by the formula (15) is selected from the following formulae (41) and (42): 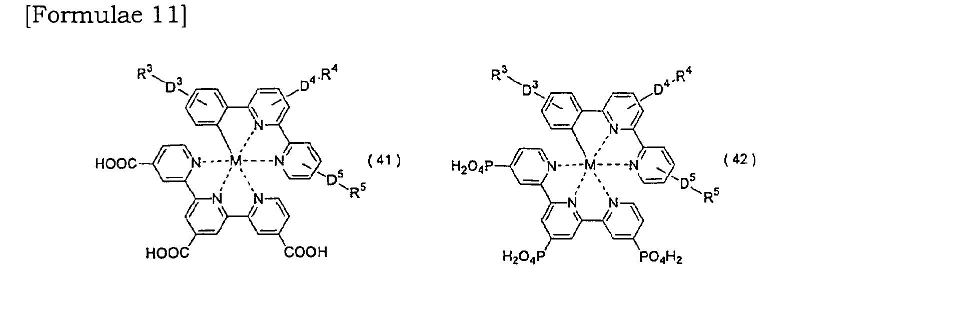 whrein D³, D⁴, D⁵, R³, R⁴ and R⁵ are the same as those defined in formula (17) of Claim 3,

14. A pyridine type metal complex according to claim 13, wherein the pyridine type metal complex represented by the formula (15) is represented by the formula (41).

15. A photoelectrode comprising adsorbing the metal complex according to claim 1 onto a surface of a semiconductor layer.

16. A photoelectrode according to claim 15, wherein the semiconductor layer is formd semiconductor particles including titanium oxide or tin oxide.

17. A dye-sensitized solar cell comprising the photoelectrode according to claim 15.
